(19) Europäisches Patentamt
European Patent Office
Office européen des brevets

(11) EP 2 660 927 B1

(12) # EUROPEAN PATENT SPECIFICATION

(45) Date of publication and mention of the grant of the patent:
**22.08.2018 Bulletin 2018/34**

(21) Application number: **11854155.6**

(22) Date of filing: **26.12.2011**

(51) Int Cl.:
***H01G 9/20*** (2006.01)
***C08G 59/20*** (2006.01)
***C08L 63/00*** (2006.01)
***H01M 2/08*** (2006.01)
***H01M 14/00*** (2006.01)
***C08K 7/00*** (2006.01)
***H01L 31/048*** (2014.01)

(86) International application number:
**PCT/JP2011/080062**

(87) International publication number:
**WO 2012/090932 (05.07.2012 Gazette 2012/27)**

(54) **SEALANT COMPOSITION FOR PHOTOELECTRIC CONVERSION ELEMENT**

DICHTUNGSMITTELZUSAMMENSETZUNG FÜR EIN FOTOELEKTRISCHES UMWANDLUNGSELEMENT

COMPOSITION D'ÉTANCHÉITÉ POUR UN ÉLÉMENT DE CONVERSION PHOTOÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.12.2010 JP 2010289169**
**24.10.2011 JP 2011232389**

(43) Date of publication of application:
**06.11.2013 Bulletin 2013/45**

(73) Proprietor: **ThreeBond Fine Chemical Co., Ltd.**
**Sagamihara-shi**
**Kanagawa 252-0146 (JP)**

(72) Inventor: **MIKUNI, Hiroyuki**
**Hachioji-shi, Tokyo 193-8533 (JP)**

(74) Representative: **Grünecker Patent- und Rechtsanwälte**
**PartG mbB**
**Leopoldstraße 4**
**80802 München (DE)**

(56) References cited:
**WO-A1-2004/075333**
**WO-A1-2007/007671**
**JP-A- 2002 368 236**
**JP-A- 2007 087 684**
**JP-A- 2007 238 894**
**JP-A- 2010 171 069**

EP 2 660 927 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

Printed by Jouve, 75001 PARIS (FR)

## Description

TECHNICAL FIELD

The present invention relates to a sealant composition for a photoelectric conversion element, which can form a film for protecting an electrode of a dye-sensitized solar cell or the like, in which an auxiliary electrode layer is formed on a substrate, from an electrolytic solution used in the cell, or iodine and the like in the electrolytic solution.

In addition, the invention relates to a photo-curing resin composition having excellent barrier properties of allowing protection of photoelectric conversion elements, light-emitting elements and the like from the external environments, thereby ensuring long-term retention of performance capabilities of those elements, and the present composition has features that it is excellent in durability, easy to produce and so on.

BACKGROUND OF THE INVENTION

Because dye-sensitized solar cells have advantages of high photoelectric conversion efficiency, low production cost and so on, attention has focused on them as novel solar cells. Each dye-sensitized solar cell is equipped with a working electrode having on a transparent electrode substrate a porous film containing fine particles of oxide semiconductor on which a photosensitized dye is borne, a counter electrode opposed to the working electrode and an electrolyte layer formed by filling a space between the working electrode and the counter electrode with an electrolytic solution containing a polar organic solvent, such as acetonitrile. In such a dye-sensitized solar cell, fine particles of the oxide semiconductor are sensitized with a photosensitization dye which absorbs sunlight or the like, thereby functioning as a photoelectric conversion element which converts light energy into electricity.

As the transparent electrode substrate used in a dye-sensitized solar cell, a glass substrate or the like on which a transparent conductive film of ITO, FTO or the like is formed is in general use. However, since the resistivity of ITO or FTO is greater than those of metals, such as silver and gold, reduction in photoelectric conversion efficiency is caused, especially in the case of adopting a large-area working electrode.

As one of techniques to reduce the resistivity of a transparent electrode substrate, it has been studied to provide an auxiliary electrode on the surface of a transparent electrode substrate for the purpose of reducing the resistivity of the electrode (Patent Document 1).

In such a case, however, corrosion by an electrolytic solution occurs in the auxiliary electrode, and resistance in the transparent electrode substrate increases with the passage of time, so that reduction in photoelectric conversion efficiency tends to occur. Therefore, in the case of providing an auxiliary electrode on the surface of the transparent electrode substrate, it is necessary for the surface part of the auxiliary electrode to be under protection. Such a protective layer is required to tightly cover the auxiliary electrode and have excellent resistance to corrosion by the electrolytic solution.

In view of these circumstances, there has been a disclosure (Patent Document 2) of the effect that heat-curable silicone resins were used in Examples for the purpose of protecting auxiliary electrodes provided for the electrodes of dye-sensitized solar cells. However, it takes so long to cure the resins because the curing of them is achieved by heating, so that the use of such resins has a problem with productivity. In addition, the protective films using the heat-curable silicone resins were unsuccessful at protecting auxiliary electrodes from electrolytic solutions to a sufficient degree. Consequently, there occurs the inconvenience of reducing the photoelectric conversion efficiency.

Moreover, photoelectric conversion elements, such as silicon base solar cells, compound base solar cells, dye-sensitized solar cells and organic thin-film base solar cells, and light-emitting elements, such as organic ELs and light-emitting diodes (LEDs), have gained attention as green-energy or energy-saver elements.

These photoelectric conversion elements and light-emitting elements are sensitive to humidity in particular, so that, when they are used under conditions of high temperature, high humidity and so on over a prolonged period, moisture having penetrated into them from the outside causes changes or degradation in their quality, whereby their performance capabilities are reduced. Thus a sealant having an excellent property as a moisture-barrier has been required.

In addition, each dye-sensitized solar cell, as also referred to as "a wet solar cell", contains an electrolytic solution including a polar organic solvent, such as acetonitrile, in a state of filling the cell’s interior, and volatilization or leakage of the electrolytic solution causes reduction in electricity production efficiency. Thus a sealant having an excellent property as a solvent-barrier also has been required.

As to the matter of sealing up an electrolytic solution inside a dye-sensitized solar cell, Patent Document 3, for example, has disclosed the case of using a thermoplastic resin like an ionic high polymer as a sealant, but this resin material is poor in heat resistance and moisture resistance, so that the sealant cannot deliver sealing performance over an extended period.

Patent Document 4 has disclosed the technique of using a polyisobutylene resin as a sealant, and Patent Document 5 has disclosed the technique of using an $\alpha$-ethylene/non-conjugated polyene copolymer as a sealant. Completing the cure of these resins takes a long time because they are sealant of the type which are curable by heating, and they therefore have a problem with productivity.

Various studies to utilize photo-curing resins as sealant for the purpose of improving the productivity have been made. Examples of such studies include the studies in Patent Document 3 utilizing radical polymerization and the studies in Patent Documents 4 and 5 utilizing cationic polymerization.

Patent Document 6 has proposed the sealant containing a liquid saturated elastomer and a (meth)acrylate having carbon number of 10 to 22. However, such a sealant composition is insufficient in moisture-barrier property and solvent-barrier property as shown in Comparative Example 11 mentioned hereafter. Consequently, application of the composition in photoelectric conversion elements and light-emitting elements wouldn't meet expectations of increasing the longevity of those elements.

In addition, Patent Document 7 has disclosed the photo-curing sealant for photoelectric conversion elements containing a cation-polymerizable compound and a cationic initiator. However, this sealant is also insufficient in moisture-barrier property and solvent-barrier property as shown in Comparative Example 11 mentioned hereafter. Consequently, application of such a sealant in photoelectric conversion elements and light-emitting elements wouldn't meet expectations of increasing the longevity of those elements.

Further, Patent Document 8 has disclosed the photo-curing sealant for dye-sensitized solar cells, which agent contains the epoxy resin produced by hydrogenation of a bisphenol epoxy resin and a cationic initiator. However, this sealant is also insufficient in moisture-barrier property as shown in Comparative Example 13 mentioned hereafter. Consequently, application of such a sealant in photoelectric conversion elements and light-emitting elements wouldn't meet expectations of increasing the longevity of those elements.

Similar sealant compositions are disclosed in Patent Documents 9 and 10.

Under these circumstances, we had made various studies on sealant compositions having excellent moisture-barrier property and solvent-barrier property. As a result, we found that an improvement in moisture-barrier property caused a reduction in solvent-barrier property, and conversely an improvement in solvent-barrier property caused a reduction in moisture-barrier property, or equivalently, there was a trade-off relationship between the moisture-barrier property and the solvent-barrier property, and we accordingly failed to satisfy both the barrier properties.

BACKGROUND ART

Patent Document

Patent Document 1: JP-A-2003-203681
Patent Document 2: JP-A-2008-251421
Patent Document 3: JP-A-2002-343454
Patent Document 4: JP-A-2002-313443
Patent Document 5: JP-A-2009-301781
Patent Document 6: JP-A-2010-138290
Patent Document 7: WO 2004 075333
Patent Document 8: JP-A-2007-087684
Patent Document 9: JP-A-2010-171069
Patent Document 10: JP-A-2007-238894

SUMMARY OF THE INVENTION

PROBLEMS THAT THE INVENTION IS TO SOLVE

Under the foregoing circumstances, the invention has been made with an objective of providing a sealant composition for a photoelectric conversion element which, at an electrode of e.g. a dye-sensitized solar cell having an auxiliary electrode layer formed on a substrate, can form a protective film having excellent screen printability and great durability to withstand corrosion by electrolytic solutions.

And another objective of the invention is to provide a gas-barrier photo-curing resin composition which has the property of being cured with light and allows high-level compatibility between moisture-barrier and solvent-barrier properties in the sealing of photoelectric conversion elements and light-emitting elements, a sealant composition for a photoelectric conversion element and a dye-sensitized solar cell.

## MEANS FOR SOLVING THE PROBLEMS

In other words, as a result of our intensive studies to attain the foregoing objectives, we have found that the objectives can be achieved with a specific sealant composition targeted for photoelectric conversion elements, thereby completing the invention.
The gist of the invention is described below.

[1] A sealant composition for a photoelectric conversion element, comprising:

(A) a hydrogenated novolac-type epoxy resin,
(B) a cation-polymerizable compound other than the component (A), and
(C) a photo-cationic polymerization initiator,

characterized in that the component (B) is (B') an epoxy resin which is in a liquid state at room temperature of 25°C and is selected from the group consisting of hydrogenated epoxy resins and/or aromatic epoxy resins having no hydroxyl groups in a molecule thereof.
[2] The sealant composition for a photoelectric conversion element according to [1], wherein the component (A) is contained in an amount of 20 to 80 parts by mass with respect to 100 parts by mass in a total amount of the component (A) and the component (B').
[3] The sealant composition for a photoelectric conversion element according to [2], wherein the component (A) is contained in an amount of 50 to 80 parts by mass with respect to 100 parts by mass in the total amount of the component (A) and the component (B').
[4] The sealant composition for a photoelectric conversion element according to [2] or [3], wherein the aromatic epoxy resins of the component (B') having no hydroxyl groups in a molecule thereof are distilled bisphenol-type aromatic epoxy resins or resorcinol-type epoxy resins, and the hydrogenated epoxy resins of the component (B') are hydrogenated bisphenol-type epoxy resins.
[5] The sealant composition for a photoelectric conversion element according to any one of [2] to [4], which is used for protecting electrodes of dye-sensitized solar cells.
[6] The sealant composition for a photoelectric conversion element according to [1], further comprising (D) a tabular inorganic filler or a scaly inorganic filler.
[7] The sealant composition for a photoelectric conversion element according to [6], wherein a blending ratio of the component (A) and the component (B) is from (5:95) to (40:60).
[8] The sealant composition for a photoelectric conversion element according to [6] or [7], wherein the component (B) is an epoxy resin having an epoxy equivalent of 100 to 300.
[9] The sealant composition for a photoelectric conversion element according to any one of [6] to [8], wherein the component (C) is a sulfonium-based cationic initiator.
[10] A dye-sensitized solar cell, which is sealed with the sealant composition for a photoelectric conversion element according to any one of [6] to [9].

## ADVANTAGE OF THE INVENTION

According to the invention, notably the embodiments [2] to [5], it is possible to obtain sealant compositions for a photoelectric conversion element which each have the property of being cured in a short time and, can form protective film having excellent screen printability and great durability to withstand corrosion by electrolytic solutions in an electrode of e.g. a dye-sensitized solar cell with an auxiliary electrode formed on a substrate.
According to the invention, notably the embodiments [6] to [10], it is possible to obtain gas-barrier photo-curing resin compositions which each have the property of being cured in a short time and, in the sealing of photoelectric conversion elements and light-emitting elements, ensure high-level compatibility between moisture-barrier and solvent-barrier properties, and further to obtain sealant compositions for a photoelectric conversion element and dye-sensitized solar cells.

## MODE FOR CARRYING OUT THE INVENTION

Preferred embodiments of the invention are described below in detail.
To begin with, the first preferred embodiment of the invention is described.
The first preferred embodiment of the invention is a sealant composition for a photoelectric conversion element, including:

(A) a hydrogenated novolac-type epoxy resin,
(B) a cation-polymerizable compound other than the component (A) and
(C) a photo-cationic polymerization initiator;

in which the component (B) is (B') an epoxy resin that is in a liquid state at room temperature and is selected from the group consisting of hydrogenated epoxy resins and/or aromatic epoxy resins having no hydroxyl groups in a molecule thereof, and in which the component (A) is contained in an amount of 20 to 80 parts by mass with respect to 100 parts by mass in the total amount of the component (A) and the component (B').

<Component (A): Hydrogenated novolac-type epoxy resin >

The hydrogenated novolac-type epoxy resin of the component (A) is a main component for a solution of problems having been tackled by the invention, namely production of cured material capable of protecting an auxiliary electrode from electrolytic solutions, and is a component for improvement in resistance to electrolytic solutions in particular. Examples of the hydrogenated novolac-type epoxy resin of the component (A) include a hydrogenated phenol novolac-type epoxy resin, a hydrogenated cresol novolac-type epoxy resin and a hydrogenated novolac-type bisphenol A epoxy resin. Of these resins, a hydrogenated phenol novolac-type resin is preferred to the others. These resins may be used alone, or any two or more of them may be used in combination.

As to the blending ratio of the hydrogenated novolac-type epoxy resin of the component (A), it is preferable that the component (A) is contained in an amount of 20 to 80 parts by mass, more preferably 50 to 80 parts by mass, with respect to 100 parts by mass in the total amount of the component (A) and the component (B'). When the ratio of the component (A) is below 20 parts by mass, resistance of the resulting composition to electrolytic solutions is lowered, whereby the protective electrode of e.g. a dye-sensitized solar cell threatens to be eroded to result in lowering of photoelectric conversion efficiency. When the ratio of the component (A) is beyond 80 parts by mass, screen printability threatens to be lowered.

Examples of a method for producing a hydrogenated novolac-type epoxy resin of the component (A) include but not limited to a method of producing the intended resin by subjecting the aromatic nuclei of an aromatic epoxy resin to hydrogenation reaction using no solvent or an ether-type organic solvent, such as tetrahydrofuran or dioxane, in the presence of a rhodium- or ruthenium-bearing graphite catalyst. The hydrogen conversion rate of the hydrogenated novolac-type epoxy resin of the component (A) is preferably 50% or above, more preferably 70% or above, particularly preferably 80% or above. When the hydrogen conversion rate is lower than 50%, the resistance of cured material of the resin to electrolytic solutions threatens to decrease. Commercially available products include YL-7717 (produced by Mitsubishi Chemical Corporation) and so on. They may be used alone, or any two or more of them may be used in combination.

<Component (B'): Epoxy resin which is in a liquid state at room temperature and is selected from the group consisting of hydrogenated epoxy resins and/or aromatic epoxy resins having no hydroxyl groups in a molecule thereof>

The component (B') used in the first preferred embodiment of the invention is an epoxy resin having one or more glycidyl groups in the molecule thereof. Examples of the component (B') are a hydrogenated epoxy resin and an aromatic resin having no hydroxyl groups in the molecule thereof. In addition, it is preferred that the component (B') be in a liquid state at room temperature in order to lower the viscosity of the composition without reducing the resistance of the cured material to electrolytic solutions and satisfactorily perform a coating process for forming an electrode-protecting film. Those resins may be used alone, or any two or more of them may be used in combination.

Suitable examples of a hydroxyl group-free aromatic epoxy resin usable as the component (B') include a compound produced by reaction of a polyhydric phenol having at least one aromatic nucleus with epichlorohydrin and a compound produced by reaction of an alkylene oxide adduct of polyhydric phenol having at least one aromatic nucleus with epichlorohydrin, preferably a compound produced by reaction of a polyhydric phenol having at least one aromatic nucleus with epichlorohydrin.

Examples of the epoxy resin in the case where the polyhydric phenol having at least one aromatic nucleus is a bisphenol include an aromatic bisphenol A epoxy resin, the diglycidyl ether of an alkylene oxide adduct of aromatic bisphenol A, an aromatic bisphenol F epoxy resin and the diglycidyl ether of an alkylene oxide adduct of aromatic bisphenol F. Among these resins, an aromatic bisphenol A epoxy resin and an aromatic bisphenol F epoxy resin are preferable for use, and the use of a mixture of aromatic bisphenol A epoxy resin and aromatic bisphenol F epoxy resins is far preferred. By using the mixture of aromatic bisphenol A and F epoxy resins, reduction in the viscosity can be made and the composition obtained can offer good screen printability.

Further, aromatic bisphenol epoxy resins purified by distillation in a high vacuum are used to advantage. Such distilled aromatic bisphenol epoxy resins are well compatible with the component (A), so that they are preferably used

from the viewpoints of lowering the viscosity of the composition and enhancing the screen printability. Examples of commercially available products of such a distilled aromatic bisphenol A epoxy resin and/or such a distilled aromatic bisphenol F epoxy resin include EXA-850CRP, EPICLON EXA-83CRP, EPICLON EXA-830LVP and EPICLON EXA-835LV (which are products of DIC Corporation), and YDF-8170C and YD-8125 (which are products of Nippon Steel Chemical Co., Ltd.).

Moreover, suitable examples of an epoxy resin in the case where the polyhydric phenol having at least one aromatic nucleus is resorcinol include resorcinol diglycidyl ether. Examples of a commercially available product of hydroxyl group-free resorcinol diglycidyl ether include EX-201 (a product of Nagase Chemtex Corporation).

Suitable examples of the hydrogenated epoxy resin used as the component (B') include the diglycidyl ether of a hydrogenated bisphenol A epoxy resin, a hydrogenated bisphenol A-alkylene oxide adduct, a hydrogenated bisphenol F epoxy resin, and the diglycidyl ether of a hydrogenated bisphenol F-alkylene oxide adduct. Examples of commercially available products of the hydrogenated bisphenol A epoxy resin include YX-8000 and YX-8034 (products of Mitsubishi Chemical Corporation), EXA-7015 (a product of DIC Corporation) and ST3000 (a product of TOHO KASEI CO., LTD.). These products may be used alone, or any two or more thereof may be used in combination.

Examples of a method for producing a hydrogenated epoxy resin of the component (B') include but not limited to a method of producing the intended resin by subjecting the aromatic nuclei of an aromatic epoxy resin to hydrogenation reaction using no solvent or an ether-type organic solvent, such as tetrahydrofuran or dioxane, in the presence of a rhodium- or ruthenium-bearing graphite catalyst. The hydrogen conversion rate of the hydrogenated epoxy resin of the component (B') is preferably 50% or above, more preferably 70% or above, particularly preferably 80% or above. When the hydrogen conversion rate is lower than 50%, the resistance of cured material of the resin to electrolytic solutions threatens to decrease.

The epoxy equivalent of the component (B') used in the first preferred embodiment of the invention is preferably 500 or below, more preferably 400 or below. When the epoxy equivalent of the component (B') is greater than 500, the resulting cured material has a reduced cross-link density, and not only reduction in resistance to electrolytic solutions is caused, but also the resultant composition tends to become stringy to result in a concern of impairment in screen printability. Additionally, the epoxy equivalent is determined using the method of JIS K-7236 (2001).

<Component (C): Cationic initiator>

The photo-cationic polymerization initiator of the component (C) used in the first preferred embodiment of the invention is a compound which has the function of generating a cationic species when exposed to ultraviolet rays whereby initiating reaction of the epoxy groups of the component (A) or the component (B'). Examples of such a compound include an aromatic iodonium salt and an aromatic sulfonium salt. These salts may be used alone, or any two or more of them may be used in combination. Examples of the aromatic iodonium salt include diphenyliodonium tetrakis(pentafluorophenyl)borate, diphenyliodonium hexafluorophosphate, diphenyliodonium hexafluoroantimonate and di(4-nonylphenyl)iodonium hexafluorophosphoate.

Examples of the aromatic sulfonium salt include triphenylsulfonium hexafluorophosphate, triphenylsulfonium hexafluoroantimonate, triphenylsulfonium tetrakis(pentafluorophenyl)borate, 4,4'-bis[diphenylsulfonio]diphenylsulfide-bishexafluorophosphate, 4,4'-bis[di(β-hydroxyethoxy)phenylsulfonio]diphenylsulfide-bishexafluoroantimonate, 4,4'-bis[di(β-hydroxyethoxy)phenylsulfonio]diphenylsulfide-bishexafluorophosphate, 7-[di(p-toluyl)sulfonio]-2-isopropylthioxanthone hexafuloroantimonate, 7-[di(p-toluyl)sulfonio]-2-isopropylthioxanthone tetrakis(pentafluorophenyl)borate, 4-phenyhlcarbonyl-4'-diphenylsulfonio-diphenylsulfide-hexafluorophosphate, 4-(p-ter-butylphenylcarbonyl)-4'-diphenylsulfonio-diphenylsulfide-hexafluoroantimonate and 4-(p-ter-butylphenylcarbonyl)-4'-di(p-toluyl)sulfonio-diphenylsulfide-tetrakis(pentafluorophenyl)borate. However, the component (C) should not be construed as being limited to the examples recited above.

Those photo-cationic polymerization initiators may be used alone, or any two or more of them may be used in combination. The use of such a photo-cationic polymerization initiator allows room-temperature curing by irradiation with ultraviolet rays.

Of photo-cationic polymerization initiators usable as the component (C), aromatic sulfonium salts in particular are preferable because they have ultraviolet absorption characteristics even in a region of wavelengths longer than 300 nm, and thereby can ensure high ultraviolet-cure capability and provide cured material having high resistance to electrolytic solutions to allow electrode protection. Among the aromatic sulfoninum salts, aromatic sulfonium/antimonate initiators are especially preferred because the blending thereof can heighten the ability of the composition to be cured by light and can enhance the resistance of the cured material to electrolytic solutions. The blending amount of photo-cationic polymerization initiator is from 0.1 to 20 parts by mass, more preferably from 0.5 to 10 parts by mass, with respect to 100 parts by mass in a total amount of the component (A) and the component (B'). When the blending amount is lower than 0.1 parts by mass, the curing becomes insufficient and the composition cured threatens to be inferior in resistance to electrolytic solutions. On the other hand, the blending amount 20 parts by mass or more is also undesirable

because the increase in ionic substance content of the cured material brings about the possibility of eroding constituent members, such as a photoelectric conversion element and a light-emitting element.

Examples of other arbitrary components include an epoxy resin having hydroxyl groups, an epoxy resin-curing agent, a radical polymerization initiator, an inorganic filler, a radical polymerizable compound, a particulate rubberlike polymer, a thermoplastic elestomer, a plasticizer, a photosensitizer such as thioxanthone, a storage stabilizer, an antioxidant, a compound of hindered amine type, an ultraviolet absorber, a silane coupling agent, a rheology control agent, a leveling agent, an organic solvent, a drying agent, an antifoaming agent, a gap filler, and coloring agents such as pigments or dyes.

The epoxy resin-curing agent is a curing agent which induces reaction of epoxy groups in the component (A) or the component (B'), and examples thereof include imidazoles, organic acid hydrazides, acid anhydrides, amines, Lewis acids and dicyanodiamides. These compounds may be used alone, or any two or more thereof may be used in combination. Examples of the imidazoles include 2-ethyl-4-methylimidazole, 1-cyanoethyl-2-ethyl-4-methylimidazole, 2-phenyl-4-methyl-5-hydroxymethylimidazole, 1-cyanoethyl-2-phenylimidazolium-trimellitate and 2,4-diamino-6-[2-methylimidazole-(1)]-ethyl-S-triazine. Examples of the organic acid hydrazides include succinic acid dihydrazide, adipic acid dihydrazide, salicylic acid dihydrazide and oleic acid dihydrazide.

The average particle size of inorganic filler used in the first preferred embodiment of the invention is preferably 50 μm or below, more preferably 30 μm or below, particularly preferably 10 μm or below. The inorganic filler having an average particle size greater than 50 μm lowers the resistance to electrolytic solutions and threatens to make it impossible for the resultant composition to satisfy characteristics as a sealant. Additionally, the term of "average particle size" used in the invention refers to a median particle size of D50.

Furthermore, the blending amount of inorganic filler used in the first preferred embodiment of the invention is preferably from 5 to 100 parts by mass, more preferably from 7 to 80 parts by mass, particularly preferably from 10 to 70 parts by mass, with respect to 100 parts by mass in a total amount of the component (A) and the component (B'). When the inorganic filler is blended in a ratio lower than 5 parts by mass with respect to 100 parts by mass in a total amount of the component (A) and the component (B'), reduction in resistance to electrolytic solutions is caused and there is a concern that the resultant composition cannot satisfy characteristics as a sealant. On the other hand, when the inorganic filler is blended in a ratio higher than 100 parts by mass, increase in viscosity is caused and there is a concern that the resultant composition will have inferior screen printability.

Moreover, examples of a shape of the inorganic filler include a tabular shape, a scaly shape, a spherical shape, an amorphous state, an acicular shape and a fibrous shape. Inorganic fillers having these different shapes may be used alone, or any two or more of them may be used in combination. Of those shapes of the inorganic filler, the tabular shape or the scaly shape is preferable to the others because the inorganic filler having such a shape can give the resultant composition excellent resistance to electrolytic solutions. Examples of the tabular or scaly inorganic filler used suitably include smectites, such as montmorillonite, hectorite, nontronite, sauconite, saponite, beidellite and stevensite, talc, alumina, boehmite, calcium carbonate, silica, montmorillonite, mica and vermiculite. Among them, talc and mica are preferred over the others. Even inorganic fillers other than those recited above can be used so long as they have a tabular shape or a scaly shape.

Examples of the amorphous or spherical inorganic filler include particulate silica, silica, alumina, boehmite, calcium carbonate, glass, titanium oxide, barium sulfate and carbon black.

A photo radical polymerization initiator can enhance photo-curing properties when used in combination with the photo-cationic initiator of the component (C). Suitable examples of the photo radical polymerization initiator include acetophenones, such as diethoxyacetophenone, 2-hydroxy-2-methyl-1-phenylpropane-1-one, benzyl dimethyl ketal, 4-(2-hydroxyethoxy)phenyl-(2-hydroxy-2-propyl) ketone, 1-hydroxycyclohexyl phenyl ketone, 2-methyl-2-morpholino(4-thiomethylphenyl)propane-1-one, 2-benzyl-2-dimethylamino-1-(4-morpholinophenyl)butanone and 2-hydroxy-2-methyl-1-[4-(1-methylvinyl)phenyl]propanone oligomer; benzoins, such as benzoin, benzoin methyl ether, benzoin ethyl ether, benzoin isopropyl ether and benzoin isobutyl ether; benzophenones, such as benzophenone, methyl o-benzoylbenzoate, 4-phenylbenzophenone, 4-benzoyl-4'-methyl-diphenylsulfide, 3,3',4,4'-tetra(t-butylperoxycarbonyl)benzophenone, 2,4,6-trimethylbenzophenone, 4-benzoyl-N,N-dimethyl-N-[2-(1-oxo-2-propenyloxy)ethyl]benzenemethanaminium bromide and (4-benzoylbenzyl)trimethylammonium chloride; thioxanthones, such as 2-isopropylthioxanthone, 4-isopropylthioxanthone, 2,4-diethylthioxanthone, 2,4-dichlorothioxanthone, 1-chloro-4-propoxythioxanthone and 2-(3-dimethylamino-2-hydroxy)-3,4-dimethyl-9H-thioxanthone-9-one mesochloride; and acylphosphine oxide compounds, such as 2,4,6-trimethylbenzoyldiphenylphosphine oxide. Of these compounds, acetophenones and acylphosphine oxide compounds are preferable to the others. These compounds may be used alone, or any two or more of them may be used in combination.

The radical polymerizable compound is arbitrarily used for the purpose of adjusting curability and physical properties of the sealant composition for a photoelectric conversion element as the first preferred embodiment of the invention. Acryloyl group-containing compounds are adduced as examples of the radical polymerizable compound. Examples of the acryloyl group-containing compounds include 2-hydroxyethyl acrylate, 2-hydroxypropyl (meth)acrylate, 4-hydroxybutyl (meth)acrylate, 2-hydroxybutyl (meth)acrylate, isobutyl (meth)acrylate, t-butyl (meth)acrylate, isooctyl

(meth)acrylate, lauryl (meth)acrylate, stearyl (meth)acrylate, isobornyl (meth)acrylate, cyclohexyl (meth)acrylate, 2-methoxyethyl (meth)acrylate, methoxyethylene glycol (meth)acrylate, 2-ethoxyethyl (meth)acrylate, terahydrofurfuryl (meth)acrylate, benzyl (meth)acrylate, ethylcarbitol (meth)acrylate, phenoxyethyl (meth)acrylate, phenoxydiethylene glycol (meth)acrylate, phenoxypolyethylene glycol (meth)acrylate, methoxypolyethylene glycol (meth)acrylate, 2,2,2-trifluoroethyl (meth)acrylate, 2,2,3,3-tetrafluoropropyl (meth)acrylate, 1H,1H,5H-octafluoropentyl (meth)acrylate, imido (meth)acrylate, methyl (meth)acrylate, ethyl (meth)acrylatae, n-butyl (meth)acrylate, propyl (meth)acrylate, n-butyl (meth)acrylate, cyclohexyl (meth)acrylate, 2-ethylhexyl (meth)acrylate, n-octyl (meth)acrylate, isononyl (meth)acrylate, isomyristyl (meth)acrylate, 2-butoxyethyl (meth)acrylate, 2-phenoxyethyl (meth)acrylate, bicyclopentenyl (meth)acrylate, isodecyl (meth)acrylate, diethylaminoethyl (meth)acrylate, dimethylaminoethyl (meth)acrylate, 2-(meth)acryloyloxyethylsuccinic acid, 2-(meth)acryloyloxyethylhexahydrophthalic acid, 2-(meth)acryloyloxyethyl 2-hydroxypropylphthalate, glycidyl (meth)acrylate, 2-(meth)acryloyloxyethyl phosphate, 1,4-butanediol di(meth)acrylate, 1,3-butanediol di(meth)acrylate, 1,6-hexanediol di(meth)acrylate, 1,9-nonanediol di(meth)acrylate, 1,10-decanediol di(meth)acrylate, 2-n-butyl-2-ethyl-1,3-propanediol di(meth)acrylate, dipropylene glycol di(meth)acrylate, tripropylene glycol di(meth)acrylate, polypropylene glycol (meth)acrylate, ethylene glycol di(meth)acrylate, diethylene glycol di(meth)acrylate, tetraethylene glycol di(meth)acrylate, polyethylene glycol di(meth)acrylate, propylene oxide-added bisphenol A di(meth)acrylate, bisphenol A di(meth)acrylate, ethylene oxide-added bisphenol A di(meth)acrylate, ethylene oxide-added bisphenol F di(meth)acrylate, dimethyloldicyclopentanedienyl di(meth)acrylate, 1,3-butylene glycol di(meth)acrylate, neopentyl glycol di(meth)acrylate, ethylene oxide-modified isocyanuric acid di(meth)acrylate, 2-hydroxy-3-(meth)acryloyloxypropyl (meth)acrylate, carbonatediol di(meth)acrylate, pentaerythritol tri(meth)acrylate, trimethylolpropane tri(meth)acrylate, propylene oxide-added trimethylolpropane tri(meth)acrylate, ethylene oxide-added trimethylolpropane tri(meth)acrylate, caprolactone-modified trimethylolpropane tri(meth)acrylate, ethylene oxide-added isocyanuric acid tri(meth)acrylate, dipentaerythritol penta(meth)acrylate, dipentaerythritol hexa(meth)acrylate, ditrimethylolpropane tetra(meth)acrylate, pentaerythritol tetra(meth)acrylate, glycerin tri(meth)acrylate, propylene oxide-added glycerin tri(meth)acrylate, and tris(meth)acryloyloxyethyl phosphate. Of these compounds, propylene oxide-added bisphenol A di(meth)acrylate, bisphenol A di(meth)acrylate, bisphenol F di(meth)acrylate ethylene oxide-added bisphenol A di(meth)acrylate and ethylene oxide-added bisphenol F di(meth)acrylate are preferable for use in terms of compatibility with the component (A) and the component (B'). In the first preferred embodiment of the invention, the suitable blending amount of such a compound is from 0.1 to 20 parts by mass with respect to 100 parts by mass in a total amount of the component (A) and the component (B').

The thermoplastic elastomer is used as appropriate for the purpose of easing internal stress of or improving adhesion of the sealant composition for a photoelectric conversion element as the first preferred embodiment of the invention. Examples of the thermoplastic elastomer include styrene base thermoplastic elastomers, or equivalently, block copolymers made up of polystyrene blocks and polybutadiene blocks, polyisoprene blocks, polyisobutylene or like blocks, olefin base thermoplastic elastomers, urethane base thermoplastic elastomers, polyester base thermoplastic elastomers and amide base thermoplastic elastomers. Among them, styrene base thermoplastic elastomers and urethane base thermoplastic elastomers are particularly preferred over the others. Those elastomers may be used alone, or any two or more of them may be used in combination. The blending amount of such elastomers is preferably 20 parts by mass or below with respect to 100 parts by mass in a total amount of the component (A) and the component (B'). When the blending amount is higher than 20 parts by mass, there is a concern that resistance of the resultant cured material to electrolytic solutions will be lowered.

The silane coupling agent may be appropriately added as an agent for improving adhesion of the sealant composition for a photoelectric conversion element as the first preferred embodiment of the invention. Examples of such a silane coupling agent include vinylsilanes such as vinyltris(β-methoxyethoxy)silane, vinyltriethoxysilane and vinyltrimethoxysilane, acrylsilanes such as γ-methacryloxypropyltrimethoxysilane, epoxysilanes such as β-(3,4-epoxycyclohexyl)ethyltrimethoxysilane and γ-glycidoxypropyltrimethoxysilane, aminosilanes such as N-β-(aminoethyl)-γ-aminopropyttrimethoxysilane, γ-aminopropyltriethoxysilane and N-phenyl-γ-aminopropyltrimethoxysilane, and other silanes such as γ-mercaptopropyltrimethoxysilane, γ-chloropropyltrimethoxysilane, p-styryltrimethoxysilane, bis(triethoxysilylpropyl)tetrasulfide and 3-isocyanatopropyltriethoxysilane. Among them, β-(3,4-epoxycyclohexyl)ethyltrimethoxysilane and γ-glycidoxypropyltrimethoxysilane are preferably used because they can contribute more highly to close adherence to FTO glass and electrodes. The blending amount of such a silane coupling agent in the first preferred embodiment of the invention is preferably from 0.1 to 20 parts by mass with respect to 100 parts by mass in a total amount of the component (A) and the component (B'). Those silane coupling agents may be used alone, or any two or more of them may be used in combination.

The particulate rubberlike polymer may be added as appropriate for the purpose of easing internal stress of or improving adhesion of the sealant. Examples of such a rubberlike polymer include rubberlike polymers of acryl rubber type, rubberlike polymers of silicone rubber type, rubberlike polymers of olefin rubber type, rubberlike polymers of polyester rubber type and rubberlike polymers of urethane rubber type. Among them, rubberlike polymers of silicone rubber type and rubberlike polymers of olefin rubber type are preferred over the others. These different types of particulate

rubberlike polymers may be used alone, or any two or more of them may be used in combination. In the first preferred embodiment of the invention, the blending amount of such a particulate rubberlike polymer is preferably from 0.1 to 50 parts by mass with respect to 100 parts by mass in a total amount of the component (A) and the component (B').

A hydroxyl group-containing aliphatic hydrocarbon or a polyether compound may further be added to the sealant composition for a photoelectric conversion element of the first preferred embodiment of the invention. The hydroxyl group-containing aliphatic hydrocarbon or the polyether compound admixed in an appropriate amount plays a role in controlling the curing time after exposure to light because it inhibits the photo-cationic polymerization reaction of a photo-curing resin composition, whereby adjustment to workability becomes possible. The blending amount of such a compound is preferably 20 parts by mass of below with respect to 100 parts by mass in a total amount of the component (A) and the component (B'). When the blending amount is higher than 20 parts by mass, there is a concern of reduction in resistance to electrolytic solutions of cured material.

The sealant composition for a photoelectric conversion element of the first preferred embodiment of the invention has no particular restrictions as to the production method thereof, and for production of the composition, kneaders of various types, such as a mixer, a roll and an extruder, are usable. As another method, it is possible to adopt e.g. a method of homogeneously kneading additives mixed on an as needed basis under conditions of e.g. room temperature or heating and normal atmospheric pressure, reduced pressure, pressurized atmosphere or a stream of inert gas.

Examples of a method for curing the sealant composition for a photoelectric conversion element of the first preferred embodiment of the invention include a method of curing by application of heat, a method of curing by exposure to light, a method of curing by further applying heat after exposure to light and a method of curing by application of heat simultaneously with exposure to light. When the curing is carried out by heating, the temperature for the heating has no particular limits, but preferably it is of the order of 40°C to 100°C.

The light source to be used in curing by exposure to light has no particular restrictions, and examples thereof include a low-pressure mercury lamp, a medium-pressure mercury lamp, a high-pressure mercury lamp, an ultrahigh-pressure mercury lamp, a black light lamp, a microwave-excited mercury lamp, a metal halide lamp, a sodium lamp, a halogen lamp, a xenon lamp, LED, a fluorescent lamp, sunlight and electron-beam irradiation devices.

The sealant composition for a photoelectric conversion element of the first preferred embodiment of the invention can be used suitably for e.g. sealing of photoelectric conversion elements, such as silicon base solar cells, compound base solar cells, dye-sensitized solar cells and organic thin-film base solar cells. Among these uses, the present composition is preferably used for the sealing aimed at protecting electrodes of dye-sensitized solar cells because of its good screen printability and high resistance to electrolytic solutions.

Next, the second preferred embodiment of the invention is described.

The second preferred embodiment of the invention is a sealant composition for a photoelectric conversion element which, in a sealant composition for a photoelectric conversion element including

(A) a hydrogenated novolac-type epoxy resin,
(B) a cation-polymerizable compound other than the component (A) and
(C) a photo-cationic polymerization initiator,
further includes
(D) a tabular inorganic filler or a scaly inorganic filler.

<Component (A): Hydrogenated novolac-type epoxy resin >

The hydrogenated novolac-type epoxy resin of the component (A) is a main component allowing improvements in moisture-barrier and solvent-barrier properties of cured material of the composition, which improvements are objectives of the invention. Examples of the hydrogenated novolac-type epoxy resin of the component (A) include a hydrogenated phenol novolac-type epoxy resin, a hydrogenated cresol novolac-type epoxy resin and a hydrogenated novolac-type bisphenol A epoxy resin. Of these resins, a hydrogenated phenol novolac-type resin is preferred to the others. These resins may be used alone, or any two or more of them may be used in combination.

The hydrogenated novolac-type epoxy resin of the component (A) and the component (B) mentioned hereafter are preferably blended in ratios of (5-40):(60-95) by parts by mass. When the ratio of the component (A) is lower than 5 parts by mass, degradation of the solvent-barrier property tends to occur; while, when the component (A) is higher than 40 parts by mass, not only the viscosity of the composition increases whereby reduction in workability is caused, but also degradation of the moisture-barrier property tends to occur.

Examples of a method for producing a hydrogenated novolac-type epoxy resin of the component (A) include but not limited to a method of producing the intended resin by subjecting the aromatic nuclei of an aromatic epoxy resin to hydrogenation reaction using no solvent or an ether-type organic solvent, such as tetrahydrofuran or dioxane, in the presence of a rhodium- or ruthenium-bearing graphite catalyst. The hydrogen conversion rate of the hydrogenated novolac-type epoxy resin of the component (A) is preferably 50% or above, more preferably 70% or above, particularly

preferably 80% or above. When the hydrogen conversion rate is lower than 50%, the resistance of cured material of the resin to electrolytic solutions threatens to decrease. Commercially available products include YL-7717 (produced by Mitsubishi Chemical Corporation) and so on.

<Component (B): Cation-polymerizable compound>

Examples of the cation-polymerizable compound of the component (B) include an epoxy group-containing compound, an oxetane-containing compound and a vinyl ether-containing compound. Of these compounds, an epoxy group-containing compound is preferable to the others in terms of both moisture-barrier and solvent-barrier properties.

Such an epoxy group-containing compound has no particular restrictions so long as it is an epoxy group-containing compound other than that of the component (A). Examples of the epoxy group-containing compound include a bisphenol epoxy resin, an aromatic novolac-type epoxy resin, a biphenyl epoxy resin, a naphthalene epoxy resin, a dicyclopentadiene epoxy resin, an aliphatic polyol polyglycidyl ether, an epoxidized diene polymer and an alicyclic epoxy compound. These compounds may be used alone, or any two or more of them may be used in combination. Of those compounds, a bisphenol epoxy resin is preferred over the others from the viewpoint of allowing adjustment to the viscosity of the resultant sealant and retention of gas-barrier properties.

The component (B) is preferably in a liquid state at 25°C because the component (A) can be used by diluted with the component (B). The component (B) and the component (A) are preferably blended in ratios of (60-95):(5-40) by parts by mass. When the ratio of the component (B) is lower than 60 parts by mass, there occurs increase in viscosity of the resulting composition and reduction in workability, and besides, the moisture-barrier property tends to degrade; while, when the ratio of the component (B) is higher than 95 parts by mass, the solvent-barrier property tends to degrade.

The epoxy equivalent of the component (B) used in the second preferred embodiment of the invention is preferably from 100 to 300, more preferably from 120 to 240. When the epoxy equivalent is below 100, the resulting cured resin matter lacks tenacity and becomes brittle. On the other hand, the epoxy equivalent greater than 300 is undesirable because the resulting cured material has a reduced cross-link density to cause degradation in moisture-barrier and solvent-barrier properties. Additionally, the epoxy equivalent is determined using the method of JIS K-7236.

Examples of the bisphenol epoxy resin include an aromatic bisphenol A epoxy resin, the diglycidyl ether of an aromatic bisphenol A-alkylene oxide adduct, a hydrogenated bisphenol A epoxy resin, the diglycidyl ether of a hydrogenated bisphenol A-alkylene oxide adduct, an aromatic bisphenol F epoxy resin, the diglycidyl ether of an aromatic bisphenol F-alkylene oxide adduct, a hydrogenated bisphenol F epoxy resin and the diglycidyl ether of a hydrogenated bisphenol F-alkylene oxide adduct. Of these resins, aromatic bisphenol epoxy resins, notably an aromatic bisphenol A epoxy resin and an aromatic bisphenol F epoxy resin, are preferably used.

Examples of commercially available products of such an aromatic bisphenol A epoxy resin include EPIKOTE 827, EPIKOTE 828 and EPIKOTE 834 (which are products of Mitsubishi Chemical Corporation), and EPICLON 840, EPICLON 850 and EXA-850CRP (which are products of DIC Corporation). Examples of commercially available products of such a hydrogenated bisphenol A epoxy resin include YX-8000 and YX-8034 (products of Mitsubishi Chemical Corporation), and EXA-7015 (a product of DIC Corporation). Examples of commercially available products of such an aromatic bisphenol F epoxy resin include EPIKOTE 806 and EPIKOTE 807 (products of Mitsubishi Chemical Corporation), and EPICLON 830, EPICLON 830-S, EPICLON 835, EPICLON EXA-83CRP, EPICLON EXA-830LVP and EPICLON EXA-835LV (products of DIC Corporation). Examples of commercially available products of such a hydrogenated bisphenol F epoxy resin include YL-6753 (a product of Mitsubishi Chemical Corporation).

Examples of commercially available products of the biphenyl epoxy resin include YX-4000, YX-4000H, YL-6121H, YL-6640, YL-6677 and YL-7399 (products of Mitsubishi Chemical Corporation). Examples of commercially available products of the dicyclopentadiene epoxy resin include HP7200, HP7200L, HP7200H and HP7200HH (products of DIC Corporation). Examples of commercially available products of the naphthalene epoxy resin include EPICLON HP-4032, HP-4032D, HP-4700 and HP-4770 (products of DIC Corporation).

Examples of the aromatic novolac-type epoxy resin include an aromatic phenol novolac-type epoxy resin, an aromatic cresol novolac-type epoxy resin and an aromatic diphenylolpropane novolac-type epoxy resin. Examples of commercially available products of the aromatic phenol novolac-type epoxy resin include EPIKOTE 152 and EPIKOTE 154 (products of Mitsubishi Chemical Corporation), and YDCN-701, YDCN-702, YDCN-703, YDCN-704 and YDCN-500 (products of Tohto Kasei Co., Ltd.). Examples of commercially available products of the aromatic cresol novolac-type epoxy resin include N-660, N-665, N-670, N673, N-665-EXP and N-672-EXP (products of DIC Corporation).

Examples of the aliphatic polyol polyglycidyl ether include ethylene glycol diglycidyl ether, propylene glycol diglycidyl ether, neopentyl glycol diglycidyl ether, butanediol diglycidyl ether, hexanediol diglycidyl ether, cyclohexanedimethanol diglycidyl ether, polypropylene glycol diglycidyl ether, trimethylolpropane diglycidyl ether, trimethylolpropane triglycidyl ether, pentaerythritol tetragycidyl ether, sorbitol heptaglycidyl ether and sorbitol hexaglycidyl ether.

Examples of the epoxidized diene polymer include epoxidized polybutadiene and epoxidized polyisoprene.

The alicyclic epoxy compound has no particular restrictions, and examples thereof include 3,4-epoxycyclohexylmethyl-3,4-epoxycyclohexylcarboxylate and limonene diepoxide. Examples of commercially available products of such alicyclic epoxy compounds include Celoxide 2021, 2081, 2083, 2085 and 3000 (all of which are products of Daicel Corporation), and CYRACURE 6105, 6110 and 6128 (all of which are products of Union Carbide Corporation).

The oxetane compound has no particular restrictions, and examples thereof include 1,4-bis[(3-ethyl-3-oxetanylmethoxy)methyl]benzene, 1,4-bis[(3-methyl-3-oxetanylmethoxy)methyl]benzene, 3-methyl-3-glycidyloxetane, 3-ethyl-3-glycidyloxetane, 3-methyl-3-hydroxymethyloxetane and 3-ethyl-3-hydroxymethyloxetane. These compounds may be used alone, or any two or more of them may be used in combination.

Examples of the vinyl ether-containing compound include a vinyl ether compound and a propenyl ether compound.

Examples of the vinyl ether compound include ethyl vinyl ether, propyl vinyl ether, isobutyl vinyl ether, octadecyl vinyl ether, butyl vinyl ether, ethylene glycol monovinyl ether, butanediol monovinyl ether, ethylene glycol butyl vinyl ether, triethylene glycol methyl vinyl ether, cyclohexanedimethanol monovinyl ether, cyclohexanedimethanol divinyl ether, 2-ethylhexyl vinyl ether, t-butyl vinyl ether, t-amyl vinyl ether, hydroxyethyl vinyl ether, hydroxybutyl vinyl ether, cyclohexyl vinyl ether, butanediol divinyl ether, ethylene glycol divinyl ether, diethylene glycol divinyl ether, triethylene glycol divinyl ether, 1,3-butenediol divinyl ether, neopentyl glycol divinyl ether, trimethylolpropane trivinyl ether, hexanediol divinyl ether, 1,4-cyclohexanediol divinyl ether, tetraethylene glycol divinyl ether, pentaerythritol divinyl ether, pentaerythritol trivinyl ether, pentaerythritol tetravinyl ether, sorbitol tetravinyl ether, sorbitol pentavinyl ether, dipentaerythritol and hexa-vinyl ethers, ethylene glycol diethoxyvinyl ether, triethylene glycol diethoxyvinyl ether, ethylene glycol dipropylenevinyl ether, trimethylolpropane triethoxyvinyl ether, pentaerythritol tetraethoxyvinyl ether, dipentaerythritol penta- and hexa-ethoxyvinyl ethers, 2-hydroxyethyl vinyl ether, 2-hydroxypropyl vinyl ether, 4-hydroxybutyl vinyl ether, pentaerythritol trivinyl ether, 2-ethylhexyl vinyl ether chloromethyl vinyl ether and 2-chloroethyl vinyl ether. Examples of the propenyl ether compound include ethyl propenyl ether, propyl propenhyl ether, isobutyl propenyl ether, octadecyl propenyl ether, butyl propenyl ether, ethylene glycol monopropenyl ether, butanediol monopropenyl ether, ethylene glycol butyl propenyl ether, triethylene glycol methyl propenyl ether, cyclohexanedimethanol monopropenyl ether, cyclohexanedimethanol dipropenyl ether, t-butyl propenyl ether, t-amyl propenyl ether, hydroxyethyl propenyl ether, hydroxybutyl propenyl ether, cyclohexyl propenyl ether and butanediol dipropenyl ether. These ethers may be used alone, or two or more of them may be used in combination.

<Component (C): Photo-cationic polymerization initiator >

The photo-cationic polymerization initiator of the component (C) used in the second preferred embodiment of the invention is a compound which has the function of generating a cationic species when exposed to ultraviolet rays whereby initiating reaction of the epoxy groups of the component (A) or the component (B). Examples of such a compound include onium salts such as an aromatic iodonium salt and an aromatic sulfonium salt. These salts may be used alone, or any two or more of them may be used in combination. Examples of the aromatic iodonium salt include diphenyliodonium tetrakis(pentafluorophenyl)borate, diphenyliodonium hexafluorophosphate, diphenyliodonium hexafluoroantimonate and di(4-nonylphenyl)iodonium hexafluorophosphoate.

Examples of the aromatic sulfonium salt include triphenylsulfonium hexafluorophosphate, triphenylsulfonium hexafluoroantimonate, triphenylsulfonium tetrakis(pentafluorophenyl)borate, 4,4-bis[diphenylsulfonio]diphenylsulfide-bishexafluorophosphate, 4,4'-bis[di(β-hydroxyethoxy)phenylsulfonio]diphenylsulfide-bishexafluoroantimonate, 4,4'-bis[di(β-hydroxyethoxy)phenylsulfonio]diphenylsulfide-bishexafluorophosphate, 7-[di(p-toluyl)sulfonio]-2-isopropylthioxanthone hexafuloroantimonate, 7-[di(p-toluyl)sulfonio]-2-isopropylthioxanthone tetrakis(pentafluorophenyl)borate, 4-phenyhlcarbonyl-4'-diphenylsulfonio-diphenylsulfide-hexafluorophosphate, 4-(p-ter-butylphenylcarbonyl)-4'-diphenylsulfonio-diphenylsulfide-hexafluoroantimonate and 4-(p-ter-butylphenylcarbonyl)-4'-di(p-toluyl)sulfonio-diphenylsulfide-tetrakis(pentafluorophenyl)borate. However, the component (C) should not be construed as being limited to the examples recited above.

Those photo-cationic polymerization initiators may be used alone, or any two or more of them may be used in combination. The use of such a photo-cationic polymerization initiator allows room-temperature curing by irradiation with ultraviolet rays.

Of photo-cationic polymerization initiators usable as the component (C), aromatic sulfonium salts in particular are preferable because they have ultraviolet absorption characteristics even in a region of wavelengths longer than 300 nm, and thereby can ensure high ultraviolet-cure capability and provide cured material having excellent moisture-barrier and solvent-barrier properties. Among the aromatic sulfoninum salts, aromatic sulfonium/antimonate initiators, notably SP-150 and SP-170 (products of ADEKA Corporation), are preferred because the mixing thereof can heighten the ability of the composition to be cured by ultraviolet rays and can enhance gas-barrier properties. The blending amount of the photo-cationic polymerization initiator is from 0.1 to 20 parts by mass, preferably from 0.5 to 10 parts by mass, with respect to 100 parts by mass in a total amount of the component (A) and the component (B). When the blending amount is lower than 0.1 parts by mass, the curing becomes insufficient and the composition cured threatens to have neither

moisture-barrier property nor solvent-barrier property. On the other hand, the blending amount 20 parts by mass or more is also undesirable because the increase in ionic substance content of the cured material leads to a high possibility of eroding constituent members, such as a photoelectric conversion element and a light-emitting element.

<Component (D): Inorganic filler>

The inorganic filler of the component (D) is a main component which allows enhancement of moisture-barrier and solvent-barrier properties, which enhancement is an objective of the invention. The average particle size of inorganic filler used in the invention is preferably 50 μm or below, more preferably 30 μm or below, particularly preferably 10 μm or below. The inorganic filler having an average particle size greater than 50 μm lowers the moisture-barrier property and makes it impossible for the resultant composition to satisfy characteristics as a sealant. Additionally, the term of "average particle size" used in the invention refers to a median particle size of D50.

Further, the blending amount of the inorganic filler of the component (D) used in the second preferred embodiment of the invention is preferably from 5 to 100 parts by mass, more preferably from 7 to 80 parts by mass, particularly preferably from 10 to 70 parts by mass, with respect to 100 parts by mass in a total amount of the component (A) and the component (B). When the ratio of the component (D) is below 5 parts by mass with respect to 100 parts by mass in a total amount of the component (A) and the component (B), the resulting composition suffers degradation in moisture-barrier property, and comes to have no characteristics as a sealant. When the ratio of the component (D) is higher than 100 parts by mass, the sealant composition for a photoelectric conversion element of the second preferred embodiment of the invention suffers an increase in viscosity, and thereby tends to incur a significant loss in coating-work capability when put to use as a sealant.

Moreover, examples of a shape of the inorganic filler of the component (D) include a tabular shape, a scaly shape, a spherical shape, an amorphous state, an acicular shape and a fibrous shape. Inorganic fillers having these different shapes may be used alone, or any two or more of them may be used in combination. Of those shapes of the inorganic filler, the tabular shape or the scaly shape is preferable to the others because the inorganic filler having such a shape can give moisture-barrier and solvent-barrier properties . Examples of the tabular or scaly inorganic filler used suitably include smectites, such as montmorillonite, hectorite, nontronite, sauconite, saponite, beidellite and stevensite, talc, alumina, boehmite, calcium carbonate, silica, montmorillonite, mica and vermiculite. Among them, talc and mica are preferred over the others. Even inorganic fillers other than those recited above can be used so long as they have a tabular shape or a scaly shape.

Examples of the amorphous or spherical inorganic filler include particulate silica, silica, alumina, boehmite, calcium carbonate, glass, titanium oxide, barium sulfate and carbon black.

Examples of other optional components include an epoxy resin curing agent, a radical polymerization initiator, a radical-polymerizable compound, a particulate rubberlike polymer, a thermoplastic elastomer, a plasticizer, a photo sensitizer such as thioxantone, a storage stabilizer, an antioxidant, a hindered amine compound, an ultraviolet absorber, a silane coupling agent, a rheology control agent, a leveling agent, an organic solvent, a drying agent, an antifoaming agent, a gap filler, and coloring agents such as pigments or dyes.

The epoxy resin-curing agent is a curing agent which induces reaction of epoxy groups in the component (A) or the component (B), and examples thereof include imidazoles, organic acid hydrazides, acid anhydrides, amines, Lewis acids and dicyanodiamides. These compounds may be used alone, or any two or more thereof may be used in combination. Examples of the imidazoles include 2-ethyl-4-methylimidazole, 1-cyanoethyl-2-ethyl-4-methylimidazole, 2-phenyl-4-methyl-5-hydroxymethylimidazole, 1-cyanoethyl-2-phenylimidazolium-trimellitate and 2,4-diamino-6-[2-methylimidazole-(1)]-ethyl-S-triazine. Examples of the organic acid hydrazides include succinic acid dihydrazide, adipic acid dihydrazide, salicylic acid dihydrazide and oleic acid dihydrazide.

A photo radical polymerization initiator can enhance curable properties when used in combination with the photo-cationic initiator of the component (C). Suitable examples of the photo radical polymerization initiator include acetophenones, such as diethoxyacetophenone, 2-hydroxy-2-methyl-1-phenylpropane-1-one, benzyl dimethyl ketal, 4-(2-hydroxyethoxy)phenyl-(2-hydroxy-2-propyl) ketone, 1-hydroxycyclohexyl phenyl ketone, 2-methyl-2-morpholino(4-thiomethylphenyl)propane-1-one, 2-benzyl-2-dimethylamino-1 -(4-morpholinophenyl)butanone and 2-hydroxy-2-methyl-1-[4-(1-methylvinyl)phenyl]propanone oligomer; benzoins, such as benzoin, benzoin methyl ether, benzoin ethyl ether, benzoin isopropyl ether and benzoin isobutyl ether; benzophenones, such as benzophenone, methyl o-benzoylbenzoate, 4-phenylbenzophenone, 4-benzoyl-4'-methyl-diphenylsulfide, 3,3',4,4'-tetra(t-butylperoxycarbonyl)benzophenone, 2,4,6-trimethylbenzophenone, 4-benzoyl-N,N-dimethyl-N-[2-(1-oxo-2-propenyloxy)ethyl]benzenemethanaminium bromide and (4-benzoylbenzyl)trimethylammonium chloride; thioxanthones, such as 2-isopropylthioxanthone, 4-isopropylthioxanthone, 2,4-diethylthioxanthone, 2,4-dichlorothioxanthone, 1-chloro-4-propoxythioxanthone and 2-(3-dimethylamino-2-hydroxy)-3,4-dimethyl-9H-thioxanthone-9-one mesochloride; and acylphosphine oxide compounds, such as 2,4,6-trimethylbenzoyldiphenylphosphine oxide. Of these compounds, acetophenones and acylphosphine oxide compounds are preferable to the others. These compounds may be used alone, or any two or more of them may be

used in combination.

The radical polymerizable compound is arbitrarily used for the purpose of adjusting curability and physical properties of the sealant composition for a photoelectric conversion element as the second preferred embodiment of the invention. Acryloyl group-containing compounds are adduced as examples of the radical polymerizable compound. Examples of the acryloyl group-containing compounds include 2-hydroxyethyl acrylate, 2-hydroxypropyl (meth)acrylate, 4-hydroxybutyl (meth)acrylate, 2-hydroxybutyl (meth)acrylate, isobutyl (meth)acrylate, t-butyl (meth)acrylate, isooctyl (meth)acrylate, lauryl (meth)acrylate, stearyl (meth)acrylate, isobornyl (meth)acrylate, cyclohexyl (meth)acrylate, 2-methoxyethyl (meth)acrylate, methoxyethylene glycol (meth)acrylate, 2-ethoxyethyl (meth)acrylate, terahydrofurfuryl (meth)acrylate, benzyl (meth)acrylate, ethylcarbitol (meth)acrylate, phenoxyethyl (meth)acrylate, phenoxydiethylene glycol (meth)acrylate, phenoxypolyethylene glycol (meth)acrylate, methoxypolyethylene glycol (meth)acrylate, 2,2,2-trifluoroethyl (meth)acrylate, 2,2,3,3-tetrafluoropropyl (meth)acrylate, 1H,1H,5H-octafluoropentyl (meth)acrylate, imido (meth)acrylate, methyl (meth)acrylate, ethyl (meth)acrylatae, n-butyl (meth)acrylate, propyl (meth)acrylate, n-butyl (meth)acrylate, cyclohexyl (meth)acrylate, 2-ethylhexyl (meth)acrylate, n-octyl (meth)acrylate, isononyl (meth)acrylate, isomyristyl (meth)acrylate, 2-butoxyethyl (meth)acrylate, 2-phenoxyethyl (meth)acrylate, bicyclopentenyl (meth)acrylate, isodecyl (meth)acrylate, diethylaminoethyl (meth)acrylate, dimethylaminoethyl (meth)acrylate, 2-(meth)acryloyloxyethylsuccinic acid, 2-(meth)acryloyloxyethylhexahydrophthalic acid, 2-(meth)acryloyloxyethyl 2-hydroxypropylphthalate, glycidyl (meth)acrylate, 2-(meth)acryloyloxyethyl phosphate, 1,4-butanediol di(meth)acrylate, 1,3-butanediol di(meth)acrylate, 1,6-hexanediol di(meth)acrylate, 1,9-nonanediol di(meth)acrylate, 1,10-decanediol di(meth)acrylate, 2-n-butyl-2-ethyl-1,3-propanediol di(meth)acrylate, dipropylene glycol di(meth)acrylate, tripropylene glycol di(meth)acrylate, polypropylene glycol (meth)acrylate, ethylene glycol di(meth)acrylate, diethylene glycol di(meth)acrylate, tetraethylene glycol di(meth)acrylate, polyethylene glycol di(meth)acrylate, propylene oxide-added bisphenol A di(meth)acrylate, bisphenol A di(meth)acrylate, ethylene oxide-added bisphenol A di(meth)acrylate, ethylene oxide-added bisphenol F di(meth)acrylate, dimethyloldicyclopentanedienyl di(meth)acrylate, 1,3-butylene glycol di(meth)acrylate, neopentyl glycol di(meth)acrylate, ethylene oxide-modified isocyanuric acid di(meth)acrylate, 2-hydroxy-3-(meth)acryloyloxypropyl (meth)acrylate, carbonatediol di(meth)acrylate, pentaerythritol tri(meth)acrylate, trimethylolpropane tri(meth)acrylate, propylene oxide-added trimethylolpropane tri(meth)acrylate, ethylene oxide-added trimethylolpropane tri(meth)acrylate, caprolactone-modified trimethylolpropane tri(meth)acrylate, ethylene oxide-added isocyanuric acid tri(meth)acrylate, dipentaerythritol penta(meth)acrylate, dipentaerythritol hexa(meth)acrylate, ditrimethylolpropane tetra(meth)acrylate, pentaerythritol tetra(meth)acrylate, glycerin tri(meth)acrylate, propylene oxide-added glycerin tri(meth)acrylate, and tris(meth)acryloyloxyethyl phosphate. Of these compounds, propylene oxide-added bisphenol A di(meth)acrylate, bisphenol A di(meth)acrylate, bisphenol F di(meth)acrylate ethylene oxide-added bisphenol A di(meth)acrylate and ethylene oxide-added bisphenol F di(meth)acrylate are preferable for use in terms of compatibility with the components (A). In the first preferred embodiment of the invention, the suitable blending amount of such a compound is from 0.1 to 20 parts by mass with respect to 100 parts by mass in a total amount of the component (A) and the component (B').

The thermoplastic elastomer is used as appropriate for the purpose of easing internal stress of or improving adhesion of the sealant composition for a photoelectric conversion element as the second preferred embodiment of the invention. Examples of the thermoplastic elastomer include styrene base thermoplastic elastomers, or equivalently, block copolymers made up of polystyrene blocks and polybutadiene blocks, polyisoprene blocks, polyisobutylene or like blocks, olefin base thermoplastic elastomers, urethane base thermoplastic elastomers, polyester base thermoplastic elastomers and amide base thermoplastic elastomers. Among them, styrene base thermoplastic elastomers and urethane base thermoplastic elastomers are particularly preferred over the others. Those elastomers may be used alone, or any two or more of them may be used in combination. The blending amount of such elastomers is preferably 20 parts by mass or below with respect to 100 parts by mass in a total amount of the component (A) and the component (B). When the blending amount is higher than 20 parts by mass, there is a concern that moisture-barrier property of the resultant cured material will be lowered.

The silane coupling agent may be appropriately added as an agent for improving adhesion of the sealant composition for a photoelectric conversion element of the second preferred embodiment of the invention. Examples of such a silane coupling agent include vinylsilanes such as vinyltris(β-methoxyethoxy)silane, vinyltriethoxysilane and vinyltrimethoxysilane, acrylsilanes such as γ-methacryloxypropyltrimethoxysilane, epoxysilanes such as β-(3,4-epoxycyclohexyl)ethyltrimethoxysilane and γ-glycidoxypropyltrimethoxysilane, aminosilanes such as N-β-(aminoethyl)-γ-aminopropyltrimethoxysilane, γ-aminopropyltriethoxysilane and N-phenyl-γ-aminopropyltrimethoxysilane, and other silanes such as γ-mercaptopropyltrimethoxysilane and γ-chloropropyltrimethoxysilane. The blending amount of such a silane coupling agent is preferably from 0.1 to 20 parts by mass with respect to 100 parts by mass in a total amount of the component (A) and the component (B) in the second preferred embodiment of the invention. Those silane coupling agents may be used alone, or any two or more of them may be used in combination.

The particulate rubberlike polymer may be added as appropriate for the purpose of easing internal stress of or improving adhesion of the sealant. Examples of such a rubberlike polymer include rubberlike polymers of acryl rubber type, rubberlike polymers of silicone rubber type, rubberlike polymers of olefin rubber type, rubberlike polymers of

polyester rubber type and rubberlike polymers of urethane rubber type. Among them, rubberlike polymers of silicone rubber type and rubberlike polymers of olefin rubber type are preferred over the others. These different types of particulate rubberlike polymers may be used alone, or any two or more of them may be used in combination. In the second preferred embodiment of the invention, the blending amount of such a particulate rubberlike polymer is preferably from 0.1 to 50 parts by mass with respect to 100 parts by mass in a total amount of the component (A) and the component (B).

A hydroxyl group-containing aliphatic hydrocarbon or a polyether compound may further be added to the sealant composition for a photoelectric conversion element of the second preferred embodiment of the invention. The hydroxyl group-containing aliphatic hydrocarbon or the polyether compound admixed in an appropriate amount plays a role in controlling the curing time after exposure to light because it inhibits the photo-cationic polymerization reaction of a photo-curing resin composition, whereby adjustment to workability becomes possible. The blending amount of such a compound is preferably 20 parts by mass of below with respect to 100 parts by mass in a total amount of the component (A) and the component (B'). When the blending amount is higher than 20 parts by mass, there is a concern of reduction in moisture-barrier property of cured material.

The expression of "a solvent-barrier property" in this embodiment means that the electrolytic-solution permeability of 200 μm-thick cured material is preferably 40 $g/m^2 \cdot 24h$ or below, more preferably 25 $g/m^2 \cdot 24h$ or below, particularly preferably 10 $g/m^2 \cdot 24h$ or below, as determined by the dish method for water-vapor permeability testing based on JIS Z 0208(1976). When the electrolytic-solution permeability is greater than 40 $g/m^2 \cdot 24h$, the function of cured material as an electrolytic-solution barrier becomes insufficient, and consequently there is a concern that, in photoelectric conversion elements, such as dye-sensitized solar cells, into which electrolytic solutions are sealed, vaporization or leakage of the electrolytic solutions may occur to incur reduction in electric-power generation efficiency. The term of "cured material" used herein refers to the material obtained by irradiating the sealant composition for a photoelectric conversion element of the second preferred embodiment of the invention by means of a UV irradiator until the integrated amount of UV light reaches 60 $kJ/cm^2$, and then by heating the resulting composition under an atmosphere of 80°C for 60 minutes.

The expression of "a moisture-barrier property" in this embodiment means that the moisture permeability of 200 μm-thick cured material is preferably 50 $g/m^2 \cdot 24h$ or below, more preferably 40 $g/m^2 \cdot 24h$ or below, particularly preferably 30 $g/m^2 \cdot 24h$ or below, as determined under conditions of 85°C and 85% RH (humidity) in accordance with the dish method for water-vapor permeability testing based on JIS Z 0208. When the electrolytic-solution permeability is greater than 50 $g/m^2 \cdot 24h$, the function of cured material as a moisture-barrier becomes insufficient, and consequently there is a concern that photoelectric conversion elements and light-emitting elements may suffer degradation or deterioration from an external moisture invasion to result in performance decrease. The term of "cured material" used herein refers to the matter obtained by irradiating the sealant composition for a photoelectric conversion element of the second preferred embodiment of the invention by means of a UV irradiator until the integrated amount of UV light reaches 60 $kJ/cm^2$, and then by heating the resulting composition under an atmosphere of 80°C for 60 minutes.

The sealant composition for a photoelectric conversion element of the second preferred embodiment of the invention has no particular restrictions as to the production method thereof, and for production of the composition, kneaders of various types, such as a mixer, a roll and an extruder, are usable. As another method, it is possible to adopt e.g. a method of homogeneously kneading additives mixed on an as needed basis under conditions of e.g. room temperature or heating and normal atmospheric pressure, reduced pressure, pressurized atmosphere or a stream of inert gas.

Examples of a method for curing the sealant composition for a photoelectric conversion element of the second preferred embodiment of the invention include a method of curing by application of heat, a method of curing by exposure to light, a method of curing by further applying heat after exposure to light and a method of curing by application of heat simultaneously with exposure to light. When the curing is carried out by heating, the temperature for the heating has no particular limits, but preferably it is of the order of 40°C to 100°C.

The light source to be used in curing by exposure to light has no particular restrictions, and examples thereof include a low-pressure mercury lamp, a medium-pressure mercury lamp, a high-pressure mercury lamp, an ultrahigh-pressure mercury lamp, a black light lamp, a microwave-excited mercury lamp, a metal halide lamp, a sodium lamp, a halogen lamp, a xenon lamp, LED, a fluorescent lamp, sunlight and electron-beam irradiation devices.

The sealant composition for a photoelectric conversion element of the second preferred embodiment of the invention has no particular restrictions as to its uses, and it is suitable for various uses, e.g. as an adhesive, a sealant, a sealing film, a coating agent, a lining agent, a potting agent and so on. Of these uses, the use as a sealant is preferable to the others.

The sealant composition for a photoelectric conversion element of the second preferred embodiment of the invention can be used suitably for sealing photoelectric conversion elements, such as a silicon base solar cell, a compound base solar cell, a dye-sensitized solar cell and an organic thin-film base solar cell, light-emitting elements, such as an organic EL and a light-emitting diode (LED), and displays, such as a liquid-crystal display, an organic EL display and an inorganic EL display. Of these uses, the use as a photoelectric conversion element and the use as a light-emitting element are especially preferable to the others. Additionally, electronic components utilizing the present sealant are also

included in the second preferred embodiment of the invention.

EXAMPLES

The preferred embodiments of invention will now be illustrated in further detail by reference to the following examples, but they should not be construed as being limited to these examples.

In the first place, examples of the first preferred embodiment of the invention are described.

<Examples 1 to 9 and Comparative Examples 1 to 10>

The following components were prepared to compound them into compositions.

Component (A):

(a-1) A hydrogenated phenol novolac-type epoxy resin (epoxy equivalent: 189, appearance: semisolid at 25°C, trade name: YL-7717, a product of Mitsubishi Chemical Corporation)

Comparative component for Component (A):

(a'-1) An aromatic phenol novolac-type epoxy resin (epoxy equivalent: 176-178, appearance: highly viscous liquid at 25°C, trade name: EPIKOTE 152, a product of Mitsubishi Chemical Corporation)

Component (B'):

(b-1) A hydrogenated bisphenol A epoxy resin (epoxy equivalent: 205, appearance: liquid at 25°C, viscosity: 1,900 mPa·s, trade name: YX-8000, a product of Mitsubishi Chemical Corporation)

(b-2) A mixture of distilled hydroxyl-free aromatic bisphenol A epoxy resin and distilled hydroxyl-free aromatic bisphenol F epoxy resin (epoxy equivalent: 165, appearance: liquid at room temperature, viscosity: 2,260 mPa·s, trade name: EXA-835LV, a product of DIC Corporation)

(b-3) A mixture of distilled hydroxyl-free aromatic bisphenol A epoxy resin and distilled hydroxyl-free aromatic bisphenol F epoxy resin (epoxy equivalent: 160, appearance: liquid at 25°C, viscosity: 1,510 mPa·s, trade name: EXA-830LVP, a product of DIC Corporation)

(b-4) Resorcinol diglycidyl ether (epoxy equivalent: 117, appearance: liquid at 25°C, viscosity: 250 mPa·s, trade name: EX-201, a product of Nagase ChemteX Corporation)

Comparative component for Component (B):

(b'-1) A hydroxyl-containing aromatic bisphenol F epoxy resin (epoxy equivalent: 160-175, appearance: liquid at 25°C, viscosity: 3,600 mPa·s, trade name: EPIKOTE 807, a product of Mitsubishi Chemical Corporation)

(b'-2) A hydroxyl-containing aromatic bisphenol A epoxy resin (epoxy equivalent: 184-194, appearance: liquid, viscosity: 13,600 mPa·s, trade name: EPIKOTE 828US, a product of Mitsubishi Chemical Corporation)

(b'-3) A hydroxyl-containing bisphenol A epoxy resin (solid at room temperature, epoxy equivalent: 670-770, trade name: EPIKOTE 1003, a product of Mitsubishi Chemical Corporation)

(b'-4) A hydroxyl-containing t-butylcatechol epoxy resin (a compound represented by the following structural formula (1))(epoxy equivalent: 200-250, appearance: liquid at room temperature, viscosity: 1,770 mPa·s, trade name: HP-820, a product of DIC Corporation)

[Chem. 1]

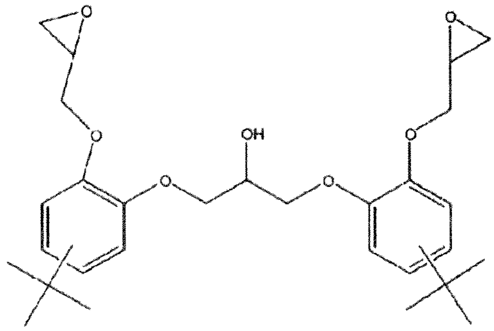

(1)

Component (C):

(c-1) An aromatic sulfonium/antimonate cationic initiator (SP-170, a product of ADEKA Corporation)
(c-2) An aromatic iodonium cationic initiator (SR-1012, a product of Sartomer Company)

Other component:

3-Glycidoxypropyltrimethoxysilane (KBM403, a product of Shin-Etsu Chemical Co., Ltd.)
Each composition was prepared by blending the components (A) to (C) in ratios as specified in Tables 1 and 2 with stirring for 180 minutes under reduced pressure by means of a planetary mixer. Additionally, the values of ratios shown in the tables are all expressed in parts by mass.
Each of the compositions prepared in Examples 1 to 9 and Comparative Examples 1 to 10 was subjected to electrolytic-solution resistance testing.

[Screen Printability]

An FTO glass plate (25 mm × 50 mm) with a silver electrode attached (which was 200 μm in grid line width, 30 mm in length and 30 μm in thickness) was prepared, and screen printing with each composition was done to form a coat on the surface of the silver electrode provided on the FTO glass plate. Thus the screen printability of each composition was evaluated by visual observations.

Screen printing conditions:

Mesh: 350 meshes (made of SUS)
Squeegee speed: 25 mm/sec
Squeegee angle: 20°

(Evaluation Criteria)

Good: A composition is rated as "good" when the formation of a uniform coat from the composition is observed.
Bad: A composition is rated as "bad" when any one of the following [1] to [4] is observed.

[1] A situation in which "a coat with stringy portions" or "faint streaks" is formed during the screen printing.
[2] A situation in which "trapping of air bubbles" in a resinous coat formed is noticed after the screen printing.
[3] A situation in which "oozing" or "bleeding" from a resinous coat formed occurs after the screen printing.
[4] A situation in which the composition is in a semisolid state and makes it impossible to do screen printing.

[Electrolytic-solution Resistance Testing]

An FTO glass plate (25 mm × 50 mm) with a silver electrode attached (which was 200 μm in grid line width, 30 mm in length and 30 μm in thickness) was prepared and, by using a screen printing technique, a coat of each composition was formed on the surface of the silver electrode provided on the FTO glass plate. The coat formed was irradiated by means of a UV irradiator until the integrated amount of UV light reached 60 kJ/$cm^2$, and then heated under an atmosphere of 80°C for 60 minutes. Thus the glass plate having the silver electrode covered with a protective film was made as a test sample. This test sample was immersed in an iodine-containing 3-methoxypropionitrile electrolytic solution kept at 85°C for one week. After the immersion, the test sample was observed by the naked eye and evaluated on the basis of the following criteria.

Screen printing conditions:

Mesh: 350 meshes (made of SUS)
Squeegee speed: 25 mm/sec
Squeegee angle: 20°

(Evaluation Criteria)

"Good": No corrosion of the silver electrode is recognized.
"Bad": Corrosion of the silver electrode is recognized.

Table 1

| Component | Ex. 1 | Ex. 2 | Ex. 3 | Ex. 4 | Ex. 5 | Ex. 6 | Ex. 7 | Ex. 8 | Ex. 9 |
|---|---|---|---|---|---|---|---|---|---|
| a-1 | 60 | 60 | 60 | 60 | 50 | 70 | 60 | 60 | 60 |
| a'-1 | | | | | | | | | |
| b-1 | 40 | | | | | | 20 | | |
| b-2 | | 40 | | | 50 | 30 | 20 | 40 | 40 |
| b-3 | | | 40 | | | | | | |
| b-4 | | | | 40 | | | | | |
| b'-1 | | | | | | | | | |
| b'-2 | | | | | | | | | |
| b'-3 | | | | | | | | | |
| b'-4 | | | | | | | | | |
| KBM403 | 3 | 3 | 3 | 3 | 3 | 3 | 3 | | 3 |
| c-1 | 3 | 3 | 3 | 3 | 3 | 3 | 3 | 3 | |
| c-2 | | | | | | | | | 3 |
| Screen printability | Good | Good | Good | Good | Good | Good | Good | Good | Good |
| Electrolytic-solution resistance testing | Good | Good | Good | Good | Good | Good | Good | Good | Good |

Table 2

| Component | Comp. Ex. 1 | Comp. Ex. 2 | Comp. Ex. 3 | Comp. Ex. 4 | Comp. Ex. 5 | Comp. Ex. 6 | Comp. Ex. 7 | Comp. Ex. 8 | Comp. Ex. 9 | Comp. Ex. 10 |
|---|---|---|---|---|---|---|---|---|---|---|
| a-1 | 60 | 60 | 60 | 60 | 60 | 10 | 90 | | | |
| a'-1 | | | | | | | | | 60 | |
| b-1 | | | | | | | | 100 | | 50 |
| b-2 | | | | | | 90 | 10 | | 40 | 50 |
| b-3 | | | | | | | | | | |
| b-4 | | | | | | | | | | |
| b'-1 | 40 | | 20 | | | | | | | |
| b'-2 | | 40 | 20 | | | | | | | |
| b'-3 | | | | 40 | | | | | | |
| b'-4 | | | | | 40 | | | | | |
| KBM403 | 3 | 3 | 3 | 3 | 3 | 3 | 3 | 3 | 3 | 3 |
| c-1 | 3 | 3 | 3 | 3 | 3 | 3 | 3 | 3 | 3 | 3 |
| Screen printability | Good | Bad | Good | Bad | Bad | Bad | Bad | Bad | Bad | Bad |
| Electrolytic-solution resistance testing | Bad | Bad | Bad | Bad | Bad | Bad | Not conducted | Bad | Good | Good |

Incidentally, the screen printability rated as "Bad" in Comparative Example 2 was grounded in observations of [1] and [2] among the "Bad" situations [1] to [4], the bad situation [4] was observed in Comparative Examples 4, 5 and 7, and the bad situation [3] was observed in Comparative Examples 6 and 8 to 10.
Next, examples of the second preferred embodiment of the invention are described.

<Examples 10 to 25 and Comparative Examples 11 to 19>

The following components were prepared to compound them into compositions.

Component (A):

(a-1) A hydrogenated phenol novolac-type epoxy resin (epoxy equivalent: 189, appearance: semisolid at 25°C, trade name: YL-7717, a product of Mitsubishi Chemical Corporation)

Component (B):

(b-1) An aromatic bisphenol F epoxy resin (epoxy equivalent: 160-170, appearance: liquid at 25°C, trade name: EPIKOTE 807, a product of Mitsubishi Chemical Corporation)
(b-2) A mixture of aromatic bisphenol A epoxy resin and aromatic bisphenol F epoxy resin (epoxy equivalent: 160-170, appearance: liquid at 25°C, trade name: EXA-835LV, a product of DIC Corporation)
(b-3) An aromatic bisphenol A epoxy resin (epoxy equivalent: 250, appearance: semisolid at 25°C, trade name: EPIKOTE 834, a product of Mitsubishi Chemical Corporation)
(b-4) A hydrogenated bisphenol A epoxy resin (epoxy equivalent: 205, appearance: liquid at 25°C, trade name: YX-8000, a product of Mitsubishi Chemical Corporation)
(b-5) An aromatic phenol novolac-type epoxy resin (non-hydrogenated phenol novolac-type epoxy resin, epoxy equivalent: 176-178, appearance: highly viscous liquid at 25°C, trade name: EPIKOTE 152, a product of Mitsubishi Chemical Corporation) Component (C):

(c-1) An aromatic sulfonium/antimonate cationic initiator (SP-170, a product of ADEKA Corporation)
(c-2) An aromatic iodonium cationic initiator (SR-1012, a product of Sartomer Company)

Component (D):

(d-1) Scaly talc 2 μm in average particle size
(d-2) Scaly mica 5 μm in average particle size
(d-3) Dimethylsilane-treated fumed silica 16 nm in average particle size (R972, a product of Nippon Aerosil Co., Ltd.)
(d-4) Pulverized crystalline silica 15 μm in average particle size (RD-8, a product of Tatsumori Ltd.)
(d-5) Spherical silica 2μm in average particle size (SO-C5, a product of Motion Tech Japan)
(d-6) Spherical alumina 10 μm in average particle size (AO-809, a product of Admatechs)

A component (A), a component (B) and a component (C) were mixed together with stirring for 30 minutes by the use of a stirrer. To the mixture obtained, a component (D) was added and further stirred for 30 minutes. Then, the resulting mixture was passed through a three roll mill, whereby the component (D) was dispersed homogeneously. Thereafter, additional stirring was carried out for 30 minutes under reduced pressure by the use of a planetary mixer. Details of the ratios are shown in Table 3, Table 4 and Comparative Example 19, and their values are all expressed in parts by weight.
Each of the sealant compositions prepared in Examples 10 to 25 and Comparative Examples 11 to 19 was subjected to moisture-permeability testing (dish method) and solvent-barrier property testing (wet dish method).

[Moisture-barrier Property Testing (Dish method)]

Each sealant composition was poured into a flame measuring 200 mm long, 200 mm wide and 0.2 mm high so that no air bubbles were trapped into the composition. Thereafter, the composition was irradiated by means of a UV irradiator until the integrated amount of UV light reached 60 kJ/$cm^2$, and further heated under an atmosphere of 80°C

for 60 minutes. Thus the composition was formed into 0.2 mm-thick sheet-shaped cured material. Calcium chloride (anhydrous) in an amount of 5 to 6 g was placed in an aluminum dish with an opening measuring 30 mm in diameter, and then the cured material was set in the dish. After "initial aggregate mass (g)" of the dish was measured, the dish was left standing in a constant temperature-and-humidity chamber kept at an atmosphere temperature of 85°C and a relative humidity of 85%, and "after-standing aggregate mass (g)" of the dish was measured every 24 hours. From these measurements, "moisture permeability ($g/m^2 \cdot 24h$)" was calculated. Details of the testing method are in conformity with JIS Z 0208.

<Evaluation Criteria>

"Excellent": less than 30 $g/m^2 \cdot 24h$
"Good": 30 to 40 $g/m^2 \cdot 24h$
"Fair": 40 to 50 $g/m^2 \cdot 24h$
"Bad": greater than 50 $g/m^2 \cdot 24h$

[Solvent-barrier Property Testing (Wet dish method)]

Each sealant composition was poured into a flame measuring 200 mm long, 200 mm wide and 0.2 mm high so that no air bubbles were trapped into the composition. Thereafter, the composition was irradiated by means of a UV irradiator until the integrated amount of UV light reached 60 $kJ/cm^2$, and further heated under an atmosphere of 80°C for 60 minutes. Thus the composition was formed into 0.2 mm-thick sheet-shaped cured material. 3-Methoxypropionitrile in an amount of 5 to 6 g was placed in an aluminum dish with an opening measuring 30 mm in diameter, and then the cured material was set in the dish. After "initial total mass (g)" of the dish was measured, the dish was left standing in a constant temperature chamber kept at an atmosphere temperature of 85°C, and "after-standing total mass (g)" of the dish was measured every 24 hours. From these measurements, "solvent permeability ($g/m^2 \cdot 24h$)" was calculated. Details of the testing method are in conformity with JIS Z 0208.

<Evaluation Criteria>

"Excellent": less than 10 $g/m^2 \cdot 24h$
"Good": 10 to 25 $g/m^2 \cdot 24h$
"Fair": 25 to 40 $g/m^2 \cdot 24h$
"Bad": greater than 40 $g/m^2 \cdot 24h$

Table 3

| Ingredient | Ex. 10 | Ex. 11 | Ex. 12 | Ex. 13 | Ex. 14 | Ex. 15 | Ex. 16 | Ex. 17 |
|---|---|---|---|---|---|---|---|---|
| a-1 | 3 | 5 | 10 | 20 | 30 | 40 | 50 | 20 |
| b-1 | 97 | 95 | 90 | 80 | 70 | 60 | 50 | |
| b-2 | | | | | | | | 80 |
| b-3 | | | | | | | | |
| b-4 | | | | | | | | |
| b-5 | | | | | | | | |
| c-1 | 3 | 3 | 3 | 3 | 3 | 3 | 3 | 3 |
| c-2 | | | | | | | | |
| d-1 | 40 | 40 | 40 | 40 | 40 | 40 | 40 | 40 |
| d-2 | | | | | | | | |
| d-4 | | | | | | | | |

(continued)

| Ingredient | Ex. 10 | Ex. 11 | Ex. 12 | Ex. 13 | Ex. 14 | Ex. 15 | Ex. 16 | Ex. 17 |
|---|---|---|---|---|---|---|---|---|
| d-5 | | | | | | | | |
| d-6 | | | | | | | | |
| Moisture-barrier property | Good | Good | Good | Good | Good | Good | Fair | Good |
| Solvent-barrier property | Fair | Good | Good | Excellent | Excellent | Excellent | Excellent | Excellent |
| Ingredient | Ex. 18 | Ex. 19 | Ex. 20 | Ex. 21 | Ex. 22 | Ex. 23 | Ex. 24 | Ex. 25 |
| a-1 | 20 | 20 | 20 | 20 | 5 | 5 | 5 | 5 |
| b-1 | 80 | 80 | | | 70 | 95 | 95 | 95 |
| b-2 | | | | | | | | |
| b-3 | | | 80 | | | | | |
| b-4 | | | | 80 | | | | |
| b-5 | | | | | 25 | | | |
| c-1 | | 3 | 3 | 3 | 3 | 3 | 3 | 3 |
| c-2 | 3 | | | | | | | |
| d-1 | 40 | | 40 | 40 | 40 | | | |
| d-2 | | 40 | | | | | | |
| d-4 | | | | | | 40 | | |
| d-5 | | | | | | | 40 | |
| d-6 | | | | | | | | 40 |
| Moisture-barrier property | Good | Good | Good | Fair | Excellent | Fair | Fair | Fair |
| Solvent-barrier property | Fair | Excellent | Fair | Excellent | Good | Fair | Fair | Fair |

Table 4

| Ingredient | Comp. Ex. 11 | Comp. Ex. 12 | Comp. Ex. 13 | Comp. Ex. 14 | Comp. Ex. 15 | Comp. Ex. 16 | Comp. Ex. 17 | Comp. Ex. 18 |
|---|---|---|---|---|---|---|---|---|
| a-1 | | 20 | | | | | | 100 |
| b-1 | | 80 | | 80 | 100 | | | |
| b-2 | 100 | | | | | 100 | 80 | |
| b-3 | | | | | | | | |
| b-4 | | | 100 | | | | 20 | |
| b-5 | | | | 20 | | | | |
| c-1 | 3 | 3 | 3 | 3 | 3 | 3 | 3 | 3 |
| d-1 | | | | 40 | 40 | 40 | 40 | 40 |
| d-3 | 10 | | 10 | | | | | |

(continued)

| Ingredient | Comp. Ex. 11 | Comp. Ex. 12 | Comp. Ex. 13 | Comp. Ex. 14 | Comp. Ex. 15 | Comp. Ex. 16 | Comp. Ex. 17 | Comp. Ex. 18 |
|---|---|---|---|---|---|---|---|---|
| Moisture-barrier property | Bad | Bad | Bad | Good | Good | Good | Bad | * |
| Solvent-barrier property | Bad | Bad | Fair | Bad | Bad | Bad | Fair | |
| * The composition prepared was highly viscous, and it was impossible to carry out the tests on it. | | | | | | | | |

(Comparative Example 19)

Cured material was prepared by mixing 100 parts by mass of IBX-A (isobornyl acrylate, produced by Kyoeisha Chemical Co., Ltd.), 120 parts by mass of CI-2000 (terminal carboxyl-containing hydrogenated polybutadiene, produced by NIPPON SODA CO., LTD.) and 1 parts by mass of IRUGACURE 184 (produced by BASF SE) with stirring for 30 minutes on the condition that light was shut out.

The moisture permeability of the cured material obtained was found to be 180 $g/m^2 \cdot 24h$, and rated "bad" on the foregoing criteria. The solvent permeability was found to be 395 $g/m^2 \cdot 24h$, and rated "bad" on the foregoing criteria.

<Examples 26 to 27 and Comparative Examples 20 to 21>

(Making of Dye-sensitized Solar Cell)

<Example 26>

A dye-sensitized solar cell was made as follows. A fluorine-doped tin oxide film-equipped transparent conductive glass (15 mm × 25 mm × 1.1 mm) having a surface resistivity of 10 Ω/□ was prepared. On the conductive surface of the glass, screen printing was done using a titanium oxide paste, and the paste was burned at 450°C. In this way, a titanium oxide layer measuring 4 mm by 4 mm was laminated. This substrate was immersed in an acetonitrile solution containing N719 dye as a ruthenium complex for 24 hours. Thus, a working electrode with the N719 dye-adsorbed titanium oxide layer was made as a laminar composite. Next, platinum was evaporated onto the conductive surface of the same transparent conductive glass as used for the working electrode until a 100 nm-thick film was formed. Thus a counter electrode was made. For injection of an electrolytic solution, an injection hole measuring about 0.8 mm in diameter was made in the counter electrode by drilling. A coating of the photo-curing composition prepared in Example 13 was applied as a sealant in square form to the counter electrode by the use of a dispenser so as to cover an area measuring 15 mm by 15 mm, and then the counter electrode and the working electrode were bonded together. In the sealant, a spacer measuring 30 μm in size was already incorporated. And the seal width after bonding the working electrode was adjusted to reach 2 mm. Thereafter, the sealant was cured by undergoing irradiation with a UV irradiator until the integrated amount of UV light reached 30 kJ/m2, and then heating under an 80°C atmosphere for 30 minutes. An electrolytic solution was dripped into the injection hole made in the counter electrode, then the air inside the gap between the working electrode and the counter electrode was removed by carrying out vacuum suction to such an extent as not to bring the electrolytic solution to a boil, and thereafter the electrolytic solution was restored to under atmospheric pressure. In this way, the electrolytic solution completed the injection into the gap between the working electrode and the counter electrode. The electrolytic solution used herein was a solution prepared by dissolving 0.6 mol/l of MPII (1-methyl-3-propylimidazolium iodide), 0.1 mol/l of iodine and 0.5 mol/l of NMBI (N-methylbenzimidazole) in 3-methoxypropionitrile. After injecting the electrolytic solution as mentioned above, an excess electrolytic solution was wiped off, the injection hole was coated with an acrylic resin 30Y-727 (produced by ThreeBond Co., Ltd.) as a photo-curing sealant for dye-sensitized solar cells, and thereon a cover glass was stuck. The photo-curing sealant was cured by being irradiated with a UV irradiator until the integrated amount of UV light reached 30 $kJ/m^2$, thereby sealing the electrolytic solution. Thus a dye-sensitized solar cell according to the invention (Cell A) was obtained.

<Example 27>

A dye-sensitized solar cell (Cell B) was made in the same manner as in Example 26, except that the sealant

prepared in Example 22 was used.

<Comparative Example 20>

A dye-sensitized solar cell (Cell C) was made in the same manner as in Example 26, except that the sealant prepared in Comparative Example 11 was used.

<Comparative Example 21>

A dye-sensitized solar cell (Cell D) was made in the same manner as in Example 26, except that the sealant prepared in Comparative Example 19 was used.

[Testing of Electrolytic Solution Leakage]

Each of Cells A to D was subjected to high temperature testing described below. The property of sealing the electrolytic solution was evaluated by measuring the amount of leakage of the sealed electrolytic solution and calculating the rate (%) of change in mass from the initial value.

[Determination of Photoelectric Conversion Efficiency]

Each of Cells A to D was connected to an I-V tester and subjected to irradiation using a solar simulator (made by YAMASHITA DENSO), in which each cell was irradiated with 100 m $W/cm^2$ of artificial sunlight emitted from the xenon lamp and passed through the AM filter (AM-1.5), whereby its short-circuit current density, release voltage and form factor were determined from its current-voltage characteristics. From the data thus obtained, the photoelectric conversion efficiency of each cell was calculated, and further the conversion efficiency retention rate (%) of each cell was determined from cell's initial photoelectric conversion efficiency and photoelectric conversion efficiency after durability testing.

$$\text{Conversion efficiency retention rate (\%)} = (\text{Conversion efficiency after durability test/ conversion efficiency before durability test}) \times 100$$

[0123]

[Durability Tests]

Durability tests of each of Cells A to D were carried out under the following conditions.
High temperature test (85°C, 1,000 h)
High temperature and high humidity test (85°C, 85% RH (humidity), 100 h)

Conversion efficiency and leakage rate evaluations were performed on each of the cells A to D after durability tests, and results obtained are shown in Table 5.

Table 5

| | | Ex. 26 | Ex. 27 | Comp. Ex. 20 | Comp. Ex. 21 |
|---|---|---|---|---|---|
| Cell | | Cell A | Cell B | Cell C | Cell D |
| Sealant | | Ex. 13 | Ex. 22 | Comp. Ex. 11 | Comp. Ex. 19 |
| High temperature test | Electrolytic solution leakage (%) | 6 | 0 | 15 | 80 |
| | Conversion efficiency retention rate (%) | 94 | 98 | 88 | 32 |
| High temperature and high humidity test | Conversion efficiency retention rate (%) | 100 | 105 | 82 | 3 |

INDUSTRIAL APPLICABILITY

The present compositions have good screen printability and high resistance to electrolytic solutions, and they are therefore utilizable e.g. for sealing of photoelectric conversion elements such as silicon base solar cells, compound base solar cells, compound base solar cells, dye-sensitized solar cells and organic thin-film base solar cells.

Moreover, the present compositions can provide sealant ensuring high levels of compatibility between moisture-barrier and solvent-barrier properties, and they are therefore utilizable for various purposes including uses in the field of electronic materials.

## Claims

1. A sealant composition for a photoelectric conversion element, comprising:

   (A) a hydrogenated novolac-type epoxy resin,
   (B) a cation-polymerizable compound other than the component (A), and
   (C) a photo-cationic polymerization initiator,

   **characterized in that** the component (B) is (B') an epoxy resin which is in a liquid state at room temperature of 25 °C and is selected from the group consisting of hydrogenated epoxy resins and/or aromatic epoxy resins having no hydroxyl groups in a molecule thereof.

2. The sealant composition for a photoelectric conversion element according to claim 1,
   wherein the component (A) is contained in an amount of 20 to 80 parts by mass with respect to 100 parts by mass in a total amount of the component (A) and the component (B').

3. The sealant composition for a photoelectric conversion element according to claim 2, wherein the component (A) is contained in an amount of 50 to 80 parts by mass with respect to 100 parts by mass in the total amount of the component (A) and the component (B').

4. The sealant composition for a photoelectric conversion element according to claim 2 or 3, wherein the aromatic epoxy resins of the component (B') having no hydroxyl groups in a molecule thereof are distilled bisphenol-type aromatic epoxy resins or resorcinol-type epoxy resins, and the hydrogenated epoxy resins of the component (B') are hydrogenated bisphenol-type epoxy resins.

5. The sealant composition for a photoelectric conversion element according to any one of claims 2 to 4, which is used for protecting electrodes of dye-sensitized solar cells.

6. The sealant composition for a photoelectric conversion element according to claim 1, further comprising (D) a tabular inorganic filler or a scaly inorganic filler.

7. The sealant composition for a photoelectric conversion element according to claim 6, wherein a blending ratio of the component (A) and the component (B) is from (5:95) to (40:60).

8. The sealant composition for a photoelectric conversion element according to claim 6 or 7, wherein the component (B) is an epoxy resin having an epoxy equivalent of 100 to 300.

9. The sealant composition for a photoelectric conversion element according to any one of claims 6 to 8, wherein the component (C) is a sulfonium-based cationic initiator.

10. A dye-sensitized solar cell, which is sealed with the sealant composition for a photoelectric conversion element according to any one of claims 6 to 9.

## Patentansprüche

1. Dichtungszusammensetzung für ein photoelektrisches Konversionselement, umfassend:

(A) ein hydriertes Novolac-Typ Epoxyharz,
(B) eine Kation-polymerisierbare Verbindung, anders als die Komponente (A), und
(C) einen photokationischen Polymerisationsinitiator,

gekennzeichnet, dass
die Komponente (B) ein (B') Epoxyharz ist, das in einem flüssigen Stadium bei Raumtemperatur von 25°C vorliegt, und ausgewählt ist, aus der Gruppe, bestehend aus hydrierten Epoxyharzen und/oder aromatischen Epoxyharzen, besitzend keine Hydroxylgruppen in einem Molekül davon.

2. Die Dichtungszusammensetzung für ein photoelektrisches Konversionselement gemäß Anspruch 1, wobei die Komponente (A) in einer Menge von 20 bis 80 Massenteilen in Bezug auf 100 Massenteile in einer Gesamtmenge der Komponente (A) und der Komponente (B') beinhaltet ist.

3. Die Dichtungszusammensetzung für ein photoelektrisches Konversionselement gemäß Anspruch 2, wobei die Komponente (A) in einer Menge von 50 bis 80 Massenteilen in Bezug auf 100 Massenteile in der Gesamtmenge der Komponente (A) und der Komponente (B') beinhaltet ist.

4. Die Dichtungszusammensetzung für ein photoelektrisches Konversionselement gemäß Anspruch 2 oder 3, wobei die aromatischen Epoxyharze in der Komponente (B'), besitzend keine Hydroxylgruppen in einem Molekül davon, destillierte Bisphenol-Typ aromatische Epoxyharze oder Resorzinol-Typ Epoxyharze sind, und die hydrierten Epoxyharze der Komponente (B') hydrierte Bisphenol-Typ Epoxyharze sind.

5. Die Dichtungszusammensetzung für ein photoelektrisches Konversionselement gemäß irgendeinem der Ansprüche 2 bis 4, die verwendet wird zum Schützen von Elektroden von Farbstoff-sensibilisierten Solarzellen.

6. Die Dichtungszusammensetzung für ein photoelektrisches Konversionselement gemäß Anspruch 1, weiter umfassend (D) einen flachen anorganischen Füllstoff oder einen schuppigen anorganischen Füllstoff.

7. Die Dichtungszusammensetzung für ein photoelektrisches Konversionselement gemäß Anspruch 6, wobei ein Mischungsverhältnis der Komponente (A) und der Komponente (B) von (5:95) bis (40:60) ist.

8. Die Dichtungszusammensetzung für ein photoelektrisches Konversionselement gemäß Anspruch 6 oder 7, wobei die Komponente (B) ein Epoxyharz ist, besitzend einen Epoxyäquivalent von 100 bis 300.

9. Die Dichtungszusammensetzung für ein photoelektrisches Konversionselement gemäß irgendeinem der Ansprüche 6 bis 8, wobei die Komponente (C) ein Sulfonium-basierter kationischer Initiator ist.

10. Farbstoff-sensibilisierte Solarzelle, die abgedichtet ist mit der Dichtungszusammensetzung für ein photoelektrisches Konversionselement gemäß irgendeinem der Ansprüche 6 bis 9.

## Revendications

1. Composition d'étanchéité pour un élément de conversion photoélectrique, comprenant:

(A) une résine époxy de type novolaque hydrogénée,
(B) un composé polymérisable par un cation autre que le composant (A), et
(C) un initiateur de photopolymérisation photo-cationique,

**caractérisée en ce que** le composant (B) est (B') une résine époxy qui est à l'état liquide à température ambiante de 25°C et est choisie dans le groupe constitué des résines époxy hydrogénées et/ou des résines époxy aromatiques sans groupe hydroxyle dans une molécule de celles-ci.

2. Composition d'étanchéité pour un élément de conversion photoélectrique selon la revendication 1, dans laquelle le composant (A) est contenu en une quantité de 20 à 80 parties en masse par rapport à 100 parties en masse dans une quantité totale du composant (A) et du composant (B').

3. Composition d'étanchéité pour un élément de conversion photoélectrique selon la revendication 2, dans laquelle le

composant (A) est contenu en une quantité de 50 à 80 parties en masse par rapport à 100 parties en masse dans la quantité totale du composant (A) et du composant (B').

4. Composition d'étanchéité pour un élément de conversion photoélectrique selon les revendications 2 ou 3, dans laquelle les résines époxy aromatiques du composant (B') ne contenant pas de groupe hydroxyle dans l'une de leurs molécules sont des résines époxy aromatiques de type bisphénol distillé ou des résines époxy de type résorcinol, et les résines époxy hydrogénées du composant (B') sont des résines époxy de type bisphénol hydrogénées.

5. Composition d'étanchéité pour un élément de conversion photoélectrique selon l'une quelconque des revendications 2 à 4, qui l'on utilise pour protéger des électrodes de cellules solaires sensibilisées par teinture.

6. Composition d'étanchéité pour un élément de conversion photoélectrique selon la revendication 1, comprenant en outre (D) une charge inorganique tabulaire ou une charge minérale écailleuse.

7. Composition d'étanchéité pour un élément de conversion photoélectrique selon la revendication 6, dans laquelle un rapport de mélange du composant (A) et du composant (B) est compris entre (5:95) et (40:60).

8. Composition d'étanchéité pour un élément de conversion photoélectrique selon les revendications 6 ou 7, dans laquelle le composant (B) est une résine époxy ayant un équivalent époxy de 100 à 300.

9. Composition d'étanchéité pour un élément de conversion photoélectrique selon l'une quelconque des revendications 6 à 8, dans laquelle le composant (C) est un initiateur cationique à base de sulfonium.

10. Cellule solaire sensibilisées par teinture, qui est étanchéifiée avec la composition d'étanchéité pour un élément de conversion photoélectrique selon l'une quelconque des revendications 6 à 9.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003203681 A
- JP 2008251421 A
- JP 2002343454 A
- JP 2002313443 A
- JP 2009301781 A
- JP 2010138290 A
- WO 2004075333 A
- JP 2007087684 A
- JP 2010171069 A
- JP 2007238894 A